# EUROPEAN PATENT APPLICATION

(11) **EP 4 722 850 A1**
(43) Date of publication of application: **08.04.2026**
(21) Application number: 24832221.6
(22) Date of filing: 02.05.2024
(51) Int. Cl.: G06F 1/16, G02B 1/14, C09J 9/00

(54) **ELECTRONIC DEVICE COMPRISING STRUCTURE FOR PROTECTING FLEXIBLE DISPLAY**

(30) Priority: 30.06.2023 KR 20230085364; 18.08.2023 KR 20230108648
(71) Applicant: Samsung Electronics Co., Ltd., Suwon-si, Gyeonggi-do 16677 (KR)
(72) Inventor: AHN, Sungho, Suwon-si Gyeonggi-do 16677 (KR); LEE, Soyoung, Suwon-si Gyeonggi-do 16677 (KR)
(74) Representative: Gulde & Partner
(86) International application number: PCT/KR2024/005965
(87) International publication number: WO 2025/005437

(57) **Abstract**

An electronic device, according to one embodiment, may comprise a camera. The electronic device may comprise a flexible display comprising: a transmission region for the light receiving of the camera; a first region surrounding the transmission region; and a deformable second region. The electronic device may comprise an adhesive layer on the flexible display, the adhesive layer comprising: a first portion disposed on the first region; and a second portion disposed on the second region. The electronic device may comprise a protection film disposed on the adhesive layer. The thickness of the first portion may be smaller than the thickness of the second portion.

## Description

### [Technical Field]

Various embodiments to be described below relate to an electronic device including a structure for protecting a flexible display.

### [Background Art]

In order for a user to easily carry an electronic device, the electronic device may be miniaturized. Despite the miniaturization of the electronic device, there is an increasing need for an electronic device in which a size of a display for displaying content is changeable, so that the user may be provided with various contents through the electronic device. For example, the electronic device may include a flexible display in which the size of the display exposed to an outside of the electronic device is changeable. The electronic device may require a structure for protecting the flexible display in which the size exposed to the outside of the electronic device is changeable.

The above-described information may be provided as a related art for the purpose of helping understanding of the present disclosure. No argument or decision is made as to whether any of the above description may be applied as a prior art related to the present disclosure.

### [Disclosure]

### [Technical Solution]

An electronic device according to an embodiment may comprise a camera. The electronic device may comprise a flexible display including a transmission region for receiving light of the camera, a first region surrounding the transmission region, and a second region which is deformable. The electronic device may comprise an adhesive layer on the flexible display including a first portion disposed on the first region, and a second portion disposed on the second region. The electronic device may comprise a protection film disposed on the adhesive layer. A property of the first portion may be different from a property of the second portion.

An electronic device according to an embodiment may comprise a camera. The electronic device may comprise a flexible display including a transmission region for receiving light of the camera and including a camera hole exposing at least a portion of the camera, a first region surrounding the transmission region, and a second region which is deformable. The electronic device may comprise an adhesive layer on the flexible display including a first portion disposed on the first region, and a second portion disposed on the second region. The electronic device may comprise a protection film disposed on the adhesive layer. A thickness of the first portion may be smaller than a thickness of the second portion. A rigidity of the first portion may be greater than a rigidity of the second portion.

### [Description of the Drawings]

FIG. 1 is a block diagram of an electronic device in a network environment according to various embodiments.
FIG. 2A is a top plan view of an exemplary electronic device in a first state.
FIG. 2B is a bottom view of an exemplary electronic device in a first state.
FIG. 2C is a top plan view of an exemplary electronic device in a second state.
FIG. 2D is a bottom view of an exemplary electronic device in a second state.
FIGS. 3A and 3B are exploded perspective views of an exemplary electronic device.
FIG. 4A is a cross-sectional view of an exemplary electronic device in a first state.
FIG. 4B is a cross-sectional view of an exemplary electronic device in a second state.
FIG. 5A is a top plan view of an exemplary electronic device in a second state.
FIG. 5B is a partial cross-sectional view of an exemplary electronic device cut along line A-A' of FIG. 5A.
FIG. 6A is a partially exploded perspective view of an exemplary electronic device in a second state.
FIG. 6B is a partial cross-sectional view of an exemplary electronic device cut along line B-B' of FIG. 6A.
FIG. 7A is a top plan view of an exemplary electronic device in an exemplary second state.
FIG. 7B is a partial cross-sectional view of an exemplary electronic device cut along line C-C' of FIG. 7A.
FIG. 8 is a partial cross-sectional view of an exemplary electronic device.
FIGS. 9A and 9B illustrate a protection film and an adhesive layer of an exemplary electronic device.
FIGS. 9C and 9D are partial cross-sectional views of an exemplary electronic device.
FIGS. 10A and 10B illustrate an exemplary electronic device.

### [Mode for Invention]

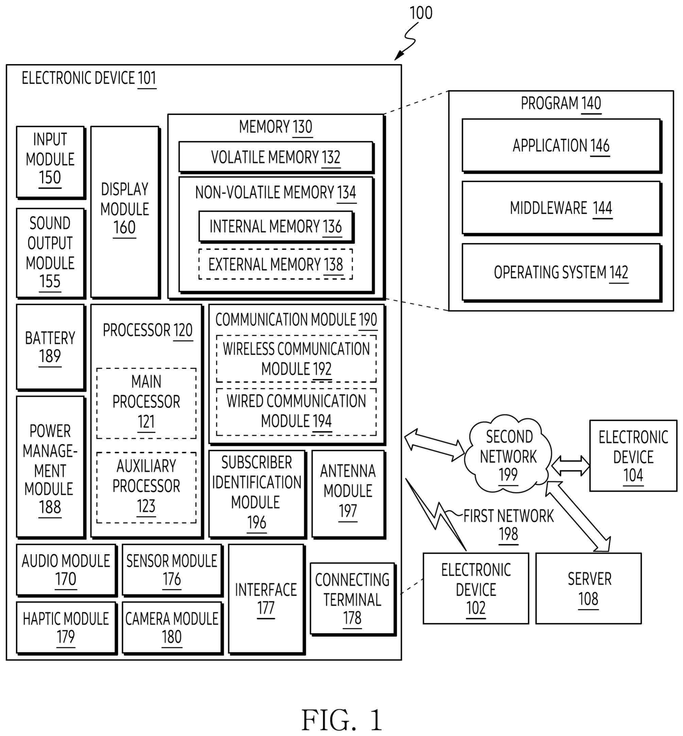

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

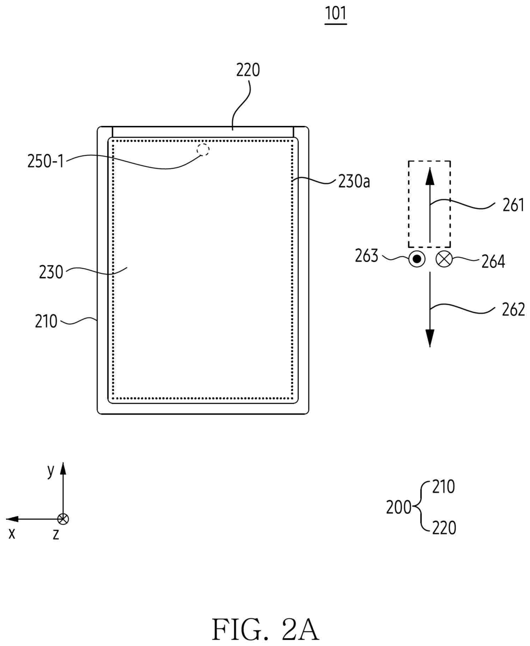

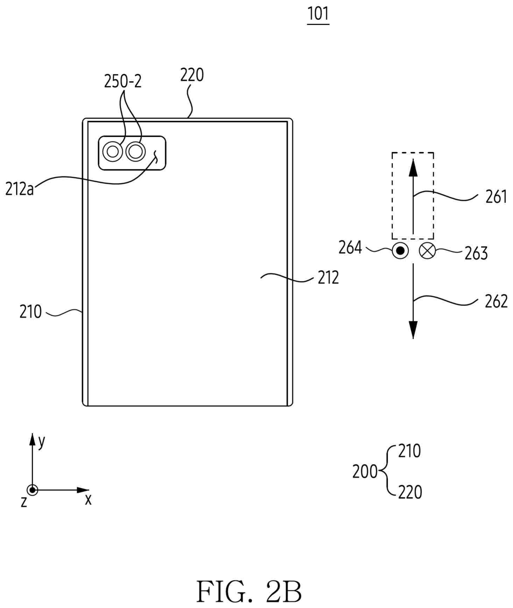

For example, a display of the display module 160 may be flexible. For example, the display may include a display area exposed outside a housing of the electronic device 101 that provides at least a portion of an outer surface of the electronic device 101. For example, since the display has flexibility, at least a portion of the display may be rollable into the housing or may be slidable into the housing. For example, a size of the display area may be changed according to a size of at least a portion of the display rolled into the housing or slid into the housing. For example, the electronic device 101 including the display may be in a plurality of states including a first state providing the display area having a first size and a second state providing the display area having a second size different from the first size. For example, the first state may be exemplified through a description of FIGS. 2A and 2B .

FIG. 2A is a top plan view of an exemplary electronic device in a first state.

Referring to FIG. 2A, an electronic device 101 may include a housing 200 that includes a first housing 210, and a second housing 220 that is movable relative to the first housing 210 in a first direction 261 parallel to a y-axis or a second direction 262 parallel to the y-axis and opposite to the first direction 261, and a display 230 (e.g., the display).

For example, the electronic device 101 may be in the first state. For example, in the first state, the second housing 220 may be movable relative to the first housing 210 in the first direction 261 among the first direction 261 and the second direction 262. For example, in the first state, the second housing 220 may not be movable relative to the first housing 210 in the second direction 262 opposite to the first direction 261.

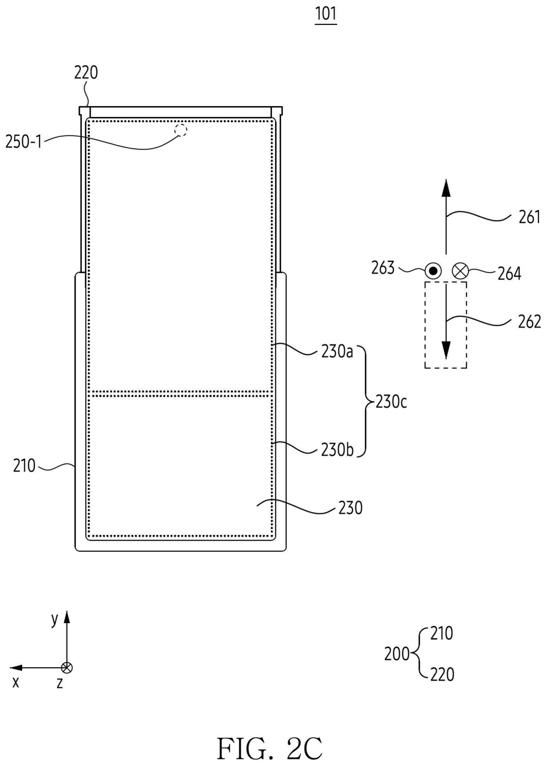

For example, in the first state, the display 230 may provide the display region having the smallest size. For example, in the first state, the display region may correspond to a region 230a. For example, although not illustrated in FIG. 2A, in the first state, a region (e.g., a region 230b of FIG. 2C) of the display 230 different from the region 230a that is the display region may be positioned in the first housing 210. For example, in the first state, the region may be covered by the first housing 210. For example, in the first state, the region may be rolled into the first housing 210. For example, in the first state, the region 230a may include a planar portion, unlike the region including a curved portion. However, it is not limited thereto. For example, in the first state, the region 230a may include a curved portion extending from the planar portion and positioned in an edge portion.

For example, the first state may be referred to as a slide-in state or a closed state in terms of at least a portion of the second housing 220 being positioned in the first housing 210. For example, the first state may be referred to as a reduced state in terms of providing the display region having the smallest size. However, it is not limited thereto.

For example, the first housing 210 may include a first image sensor 250-1 in a camera module 180, visually exposed through a portion of the region 230a and facing a third direction 263 parallel to a z-axis. For example, the camera module 180 may be disposed to perform its function without being visually exposed through the portion of the region 230a in an internal space of the electronic device. For example, although not illustrated in FIG. 2A, the second housing 220 may include one or more second image sensors in the camera module 180, exposed through a portion of the second housing 220 and facing in a fourth direction 264 parallel to the z-axis and opposite to the third direction 263. For example, the one or more second image sensors may be exemplified through a description of FIG. 2B.

FIG. 2B is a bottom view of an exemplary electronic device in a first state.

Referring to FIG. 2B, in the first state, one or more second image sensors 250-2 disposed in the second housing 220 may be positioned within a structure disposed in the first housing 210 for the one or more second image sensors 250-2. For example, in the first state, light from an outside of the electronic device 101 may be received by the one or more second image sensors 250-2 through the structure. For example, since the one or more second image sensors 250-2 are positioned in the structure in the first state, the one or more second image sensors 250-2 may be exposed through the structure in the first state. For example, the structure may be implemented in various ways. For example, the structure may be an opening or a notch. For example, the structure may be an opening 212a in a plate 212 of the first housing 210 surrounding at least a portion of the second housing 220. However, it is not limited thereto. For example, in the first state, the one or more second image sensors 250-2 included in the second housing 220 may be covered by the plate 212 of the first housing 210.

Referring back to FIG. 2A, the first state may be changed to the second state.

For example, the first state (or the second state) may be changed to the second state (or the first state) through one or more intermediate states between the first state and the second state.

For example, the first state (or the second state) may be changed to the second state (or the first state) based on a predefined user input. For example, the first state (or the second state) may be changed to the second state (or the first state) in response to a user input to a physical button exposed through a portion of the first housing 210 or a portion of the second housing 220. For example, the first state (or the second state) may be changed to the second state (or the first state) in response to a touch input to an executable object displayed within the display region. For example, the first state (or the second state) may be changed to the second state (or the first state) in response to a touch input having a contact point on the display region and having a pressing intensity of more than a reference intensity. For example, the first state (or the second state) may be changed to the second state (or the first state) in response to a voice input received through a microphone of the electronic device 101. For example, the first state (or the second state) may be changed to the second state (or the first state) in response to an external force applied to the first housing 210 and/or the second housing 220 to move the second housing 220 relative to the first housing 210. For example, the first state (or the second state) may be changed to the second state (or the first state) in response to a user input identified on an external electronic device (e.g., earbuds or smart watch) connected to the electronic device 101. However, it is not limited thereto.

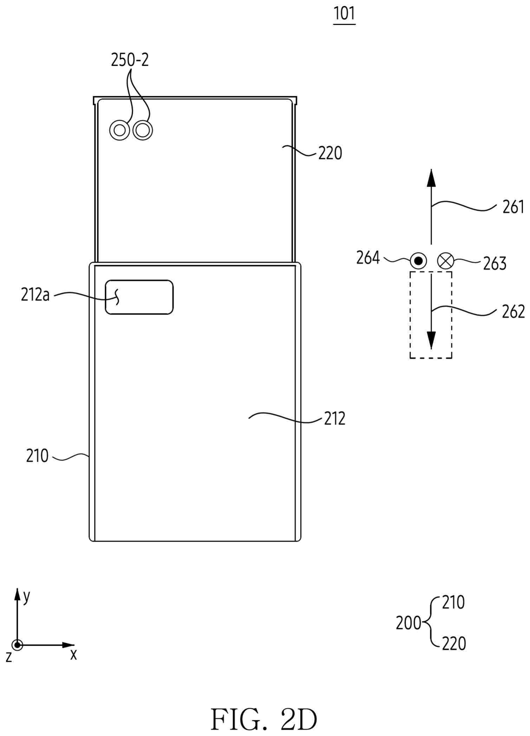

The second state may be exemplified through a description of FIGS. 2C and 2D.

FIG. 2C is a top plan view of an exemplary electronic device in a second state.

Referring to FIG. 2C, the electronic device 101 may be in the second state. For example, in the second state, the second housing 220 may be movable relative to the first housing 210 in the second direction 262 among the first direction 261 and the second direction 262. For example, in the second state, the second housing 220 may not be movable relative to the first housing 210 in the first direction 261 opposite to the second direction 262.

For example, in the second state, the display 230 may provide the display region having the largest size. For example, in the second state, the display region may correspond to a region 230c including the region 230a and the region 230b. For example, the region 230b positioned in the first housing 210 in the first state may be exposed outside the housing 210 in the second state. For example, in the second state, the region 230a may include a planar portion. However, it is not limited thereto. For example, the region 230a may include a curved portion extending from the planar portion and positioned in an edge portion. For example, in the second state, the region 230b, unlike the region 230a in the first state, may include a planar portion among the planar portion and a curved portion. However, it is not limited thereto. For example, the region 230b may include the curved portion extending from the planar portion of the region 230b and positioned in the edge portion.

For example, the second state may be referred to as a slide-out state or an open state in terms of at least a portion of the second housing 220 being positioned outside the first housing 210. For example, the second state may be referred to as an extended state in terms of providing the display region having the largest size. However, it is not limited thereto.

For example, when a state of the electronic device 101 is changed from the first state to the second state, the first image sensor 250-1 facing the third direction 263 may be moved along with the region 230a according to a movement of the second housing 220 in the second direction 262. For example, although not illustrated in FIG. 2C, when the state of electronic device 101 changes from the first state to the second state, the one or more second image sensors 250-2 facing the fourth direction 264 may be moved according to the movement of the second housing 220 in the second direction 262. For example, a relative positional relationship between the one or more second image sensors 250-2 and the structure in the first housing 210 exemplified through the description of FIG. 2B may be changed according to the movement of the one or more second image sensors 250-2. For example, the change in the relative positional relationship may be exemplified through FIG. 2D.

FIG. 2D is a bottom view of an exemplary electronic device in a second state.

Referring to FIG. 2D, in the second state, the one or more second image sensors 250-2 may be positioned outside the structure (e.g., an opening or a notch) in the first housing 210 exemplified through the description of FIG. 2B. For example, in the second state, the one or more second image sensors 250-2 may be positioned outside the opening 212a in the plate 212. For example, the one or more second image sensors 250-2 may be exposed through the opening 212a in the first state. The one or more second image sensors 250-2 may be exposed by being positioned outside the opening 212a in the second state. For example, since the one or more second image sensors 250-2 are positioned outside the structure in the second state, the relative positional relationship between the one or more second image sensors 250-2 and the structure in the first housing 210 exemplified through the description of FIG. 2B in the second state may be different from the relative positional relationship in the first state.

For example, in a case that the electronic device 101 does not include the structure, such as the opening 212a, the one or more second image sensors 250-2 in the first state may not be exposed outside the housing, but in the second state, the one or more second image sensors 250-2 may be exposed outside the housing.

Although not illustrated in FIGS. 2A, 2B, 2C, and 2D, the electronic device 101 may be in an intermediate state between the first state and the second state. For example, a size of the display region in the intermediate state may be greater than a size of the display region in the first state and smaller than a size of the display region in the second state. For example, the display region in the intermediate state may correspond to a region including the region 230a and a portion of the region 230b. For example, in the intermediate state, the portion of the region 230b may be exposed, and another portion (or a remaining portion) of the region 230b may be covered by the first housing 210 or rollable into the first housing 210. However, it is not limited thereto.

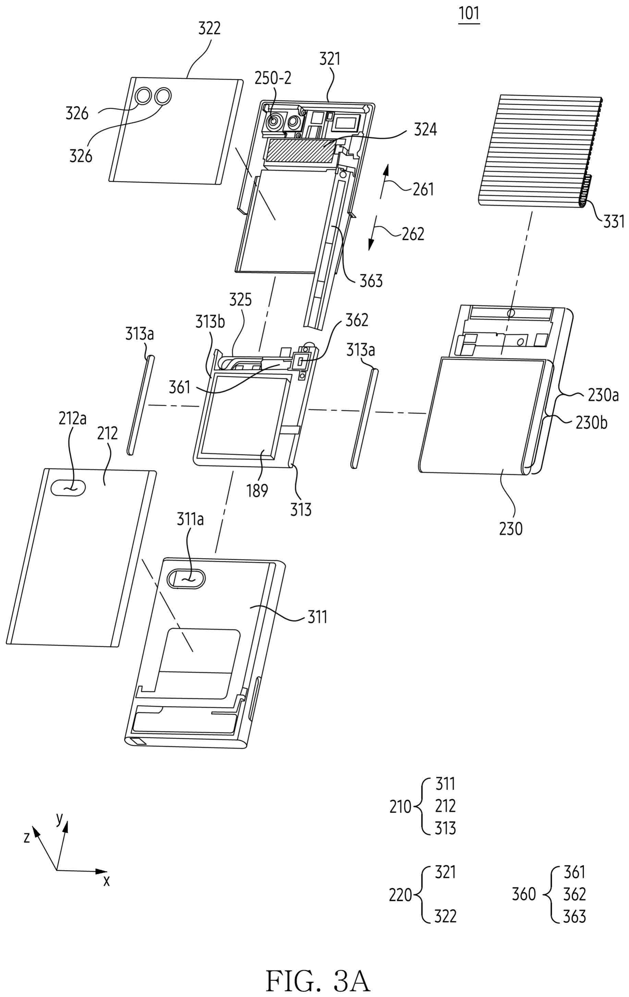

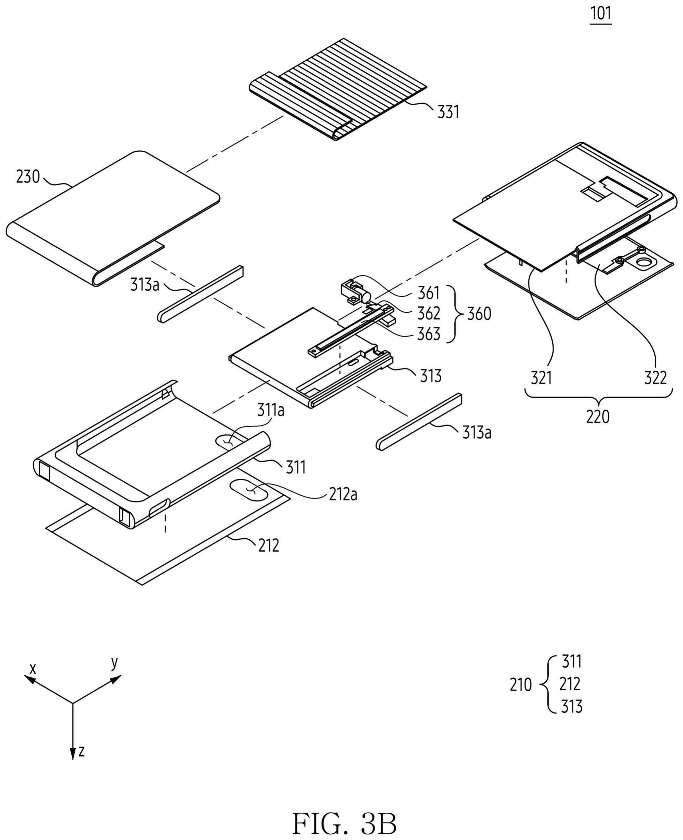

Referring back to FIG. 1, the electronic device 101 may include structures for moving a second housing (e.g., the second housing 220 of FIG. 2A) of the electronic device 101 relative to a first housing (e.g., the first housing 210 of FIG. 2A) of the electronic device 101. For example, the structures may be illustrated through a description of FIGS. 3A and 3B.

FIGS. 3A and 3B are exploded perspective views of an exemplary electronic device.

Referring to FIGS. 3A and 3B, an electronic device 101 may include a housing 200 including a first housing 210 and a second housing 220, a display 230, and a driving unit 360.

For example, the first housing 210 may include a first housing cover 311, a plate 212, and a frame cover 313.

For example, the first housing cover 311 may at least partially form a side portion of an outer surface of the electronic device 101. For example, the first housing cover 311 may at least partially form a rear portion of the outer surface. For example, the first housing cover 311 may include an opening 311a for one or more second image sensors 250-2. For example, the first housing cover 311 may include a surface supporting the plate 212. For example, the first housing cover 311 may be coupled to the plate 212. For example, the first housing cover 311 may include the frame cover 313. For example, the first housing cover 311 may be coupled to the frame cover 313.

For example, the plate 212 may at least partially form the rear portion of the outer surface. For example, the plate 212 may include an opening 212a for the one or more second image sensors 250-2. For example, the plate 212 may be disposed on the surface of the first housing cover 311. For example, the opening 212a may be aligned with the opening 311a.

For example, the frame cover 313 may be at least partially surrounded by the first housing cover 311.

For example, the frame cover 313 may be at least partially surrounded by the display 230. For example, the frame cover 313 may be at least partially surrounded by the display 230, but a position of the frame cover 313 may be maintained independently of a movement of the display 230. For example, the frame cover 313 may be arranged in association with at least a portion of components of the display 230. For example, the frame cover 313 may include rails 313a that provide (or guide) a path for movement of at least one component of the display 230.

For example, the frame cover 313 may be coupled to at least one component of the electronic device 101. For example, the frame cover 313 may support a rechargeable battery 189. For example, the battery 189 may be supported through a recess or a hole in a surface 313b of the frame cover 313. For example, the frame cover 313 may be coupled to an end of a flexible printed circuit board (FPCB) 325 on the surface of the frame cover 313. For example, although not explicitly illustrated in FIGS. 3A and 3B, another end of the FPCB 325 may be connected to a PCB 324 through at least one connector. For example, the PCB 324 may be electrically connected to another PCB (not illustrated in FIGS. 3A and 3B) that supplies power to a motor 361 through the FPCB 325.

For example, the frame cover 313 may be coupled to at least one structure of the electronic device 101 for a plurality of states including the first state and the second state. For example, the frame cover 313 may fasten the motor 361 of the driving unit 360.

For example, the second housing 220 may include a front cover 321 and a slide cover 322.

For example, the front cover 321 may be at least partially surrounded by the display 230. For example, the front cover 321 may be coupled to at least a portion of a region 230a of the display 230 surrounding the front cover 321, unlike the frame cover 313, so that the display 230 is moved along the second housing 220 that is moved relative to the first housing 210.

For example, the front cover 321 may be coupled to the at least one component of the electronic device 101. For example, the front cover 321 may be coupled to the printed circuit board (PCB) 324 including the components of the electronic device 101. For example, the PCB 324 may include a processor 120 (not illustrated in FIGS. 3A and 3B). For example, the front cover 321 may include the one or more second image sensors 250-2.

For example, the front cover 321 may be coupled to the at least one structure of the electronic device 101 for the plurality of states including the first state and the second state. For example, the front cover 321 may fasten a rack gear 363 of the driving unit 360.

For example, the front cover 321 may be coupled to the slide cover 322.

For example, the slide cover 322 may be coupled to the front cover 321 to protect the at least one component of the electronic device 101 coupled in the front cover 321 and/or the at least one structure of the electronic device 101 coupled in the front cover 321. For example, the slide cover 322 may include a structure for the at least one component. For example, the slide cover 322 may include one or more openings 326 for the one or more second image sensors 250-2. For example, the one or more openings 326 may be aligned with the one or more second image sensors 250-2 disposed on the front cover 321. For example, a size of each of the one or more openings 326 may correspond to a size of each of the one or more second image sensors 250-2.

For example, the display 230 may include a support member 331. For example, the support member 331 may include a plurality of bars. For example, the plurality of bars may be coupled to each other.

For example, the driving unit 360 may include the motor 361, a pinion gear 362, and the rack gear 363.

For example, the motor 361 may operate based on power from the battery 189. For example, the power may be provided to the motor 361 in response to a predefined user input.

For example, the pinion gear 362 may be coupled to the motor 361 through a shaft. For example, the pinion gear 362 may be rotated based on the operation of the motor 361 transmitted through the shaft.

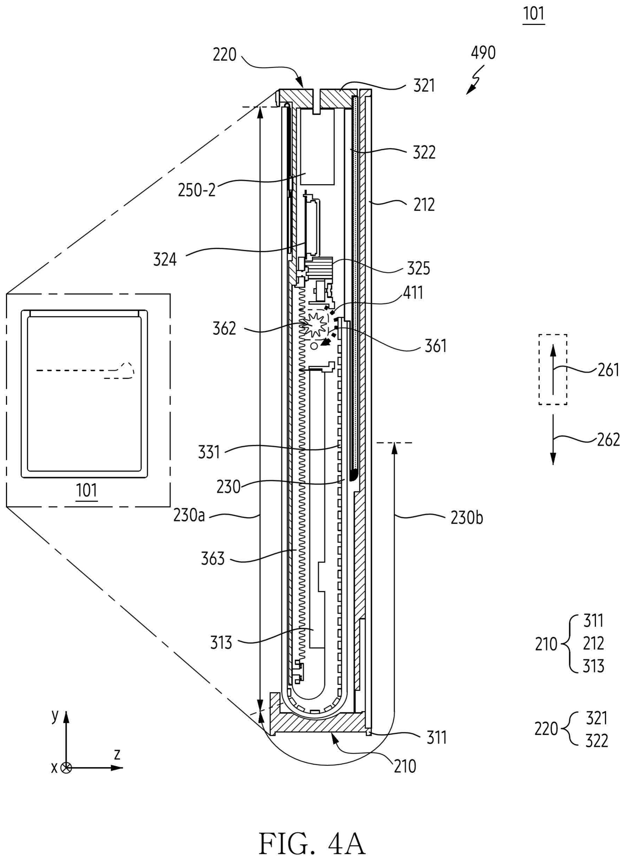

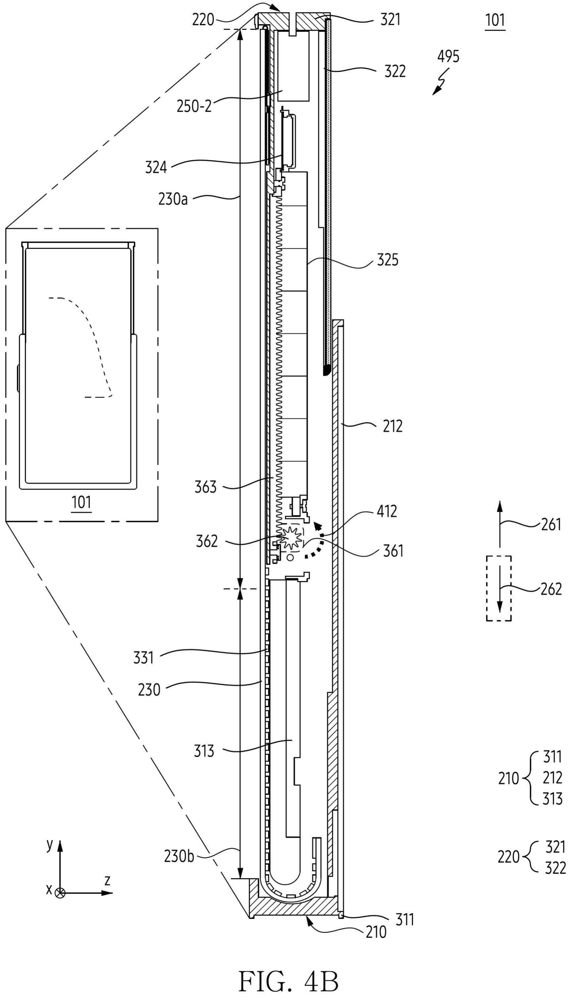

For example, the rack gear 363 may be arranged in association with the pinion gear 362. For example, teeth of the rack gear 363 may be engaged with teeth of the pinion gear 362. For example, the rack gear 363 may be moved in a first direction 261 or a second direction 262 according to rotation of the pinion gear 362. For example, the second housing 220 may be moved in the first direction 261 and the second direction 262 by the rack gear 363 moved according to the rotation of the pinion gear 362 due to the operation of the motor 361. For example, the first state of the electronic device 101 may be changed to another state (e.g., the one or more intermediate states or the second state) different from the first state through the movement of the second housing 220 in the second direction 262. For example, the second state of the electronic device 101 may be changed to another state (e.g., the one or more intermediate states or the first state) different from the second state through the movement of the second housing 220 in the first direction 261. For example, the first state being changed to the second state by the driving unit 360 and the second state being changed to the first state by the driving unit 360 may be exemplified through FIGS. 4A and 4B.

FIG. 4A is a cross-sectional view of an exemplary electronic device in a first state. FIG. 4B is a cross-sectional view of an exemplary electronic device in a second state.

Referring to FIGS. 4A and 4B, a motor 361 may be operated based at least in part on a predefined user input received in a state 490, which is the first state. For example, a pinion gear 362 may be rotated in a first rotation direction 411 based at least in part on the operation of the motor 361. For example, a rack gear 363 may be moved in a first direction 261 based at least in part on the rotation of the pinion gear 362 in the first rotation direction 411. For example, since a front cover 321 in a second housing 220 fastens the rack gear 363, the second housing 220 may be moved in the first direction 261 based at least in part on the movement of the rack gear 363 in the first direction 261. For example, since the front cover 321 in the second housing 220 is coupled to at least a portion of a region 230a of a display 230 and fastens the rack gear 363, the display 230 may be moved based at least in part on the movement of the rack gear 363 in the first direction 261. For example, the display 230 may be moved along rails 313a. For example, a shape of at least a portion of the plurality of bars of a support member 331 of the display 230 may be changed when the state 490 is changed to a state 495, which is the second state.

For example, a region 230b of the display 230 may be moved according to the movement of the display 230. For example, when the state 490 is changed to the state 495 according to the predefined user input, the region 230b may be moved through a space between a first housing cover 311 and a frame cover 313. For example, the region 230b in the state 495 may be exposed, unlike the region 230b rolled into the space in the state 490.

For example, since the front cover 321 in the second housing 220 is coupled to a PCB 324 connected to the other end of a FPCB 325 and fastens the rack gear 363, a shape of the FPCB 325 may be changed when the state 490 is changed to the state 495.

The motor 361 may be operated based at least in part on the predefined user input received in the state 495. For example, the pinion gear 362 may be rotated in a second rotation direction based at least in part on the operation of the motor 361. For example, the rack gear 363 may be moved in a second direction 262 based at least in part on the rotation of the pinion gear 362 in the second rotation direction 412. For example, since the front cover 321 in the second housing 220 fastens the rack gear 363, the second housing 220 may be moved in the second direction 262 based at least in part on the movement of the rack gear 363 in the second direction 262. For example, since the front cover 321 in the second housing 220 is coupled to the at least a portion of the region 230a of the display 230 and fastens the rack gear 363, the display 230 may be moved based at least in part on the movement of the rack gear 363 in the second direction 262. For example, the display 230 may be moved along the rails 313a. For example, the shape of the at least a portion of the plurality of bars of the support member 331 of the display 230 may be changed when the state 495 is changed to the state 490.

For example, the region 230b of the display 230 may be moved according to the movement of the display 230. For example, when the state 495 is changed to the state 490 according to the predefined user input, the region 230b may be moved through the space between the first housing cover 311 and the frame cover 313. For example, the region 230b in the state 490 may be rolled into the space, unlike the region 230b exposed in the state 495.

For example, since the front cover 321 in the second housing 220 is coupled to the PCB 324 connected to the other end of the FPCB 325 and fastens the rack gear 363, the shape of the FPCB 325 may be changed when the state 495 is changed to the state 490.

FIGS. 2A to 4B illustrate the electronic device 101 in which a height of the display region is changed and a width of the display region is maintained when the first state (or the second state) is changed to the second state (or the first state) in a portrait mode, but this is for convenience of explanation. For example, when the first state (or the second state) is changed to the second state (or the first state) in the portrait mode, the electronic device 101 may be implemented such that the height of the display region is maintained and the width of the display region is changed.

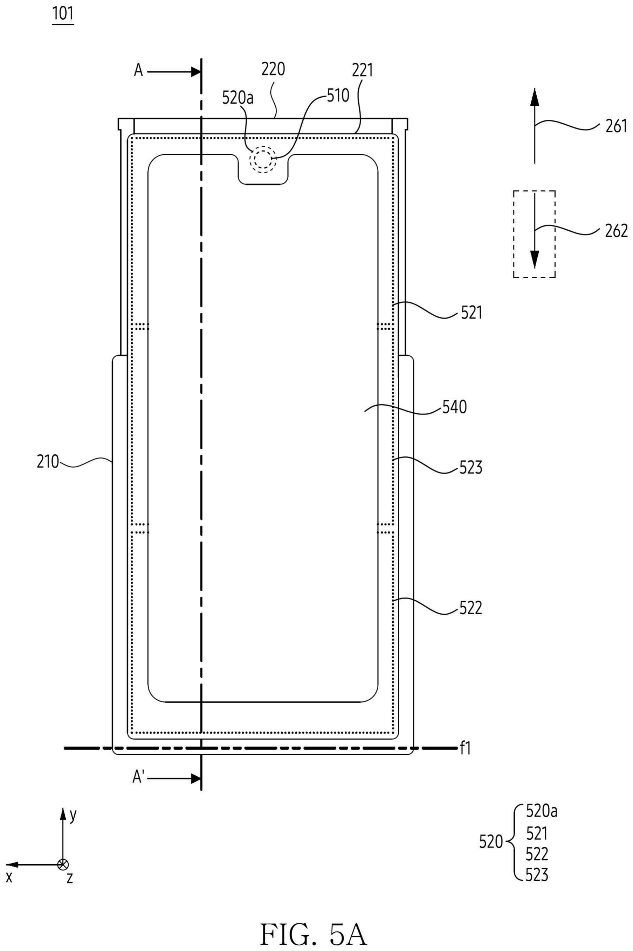

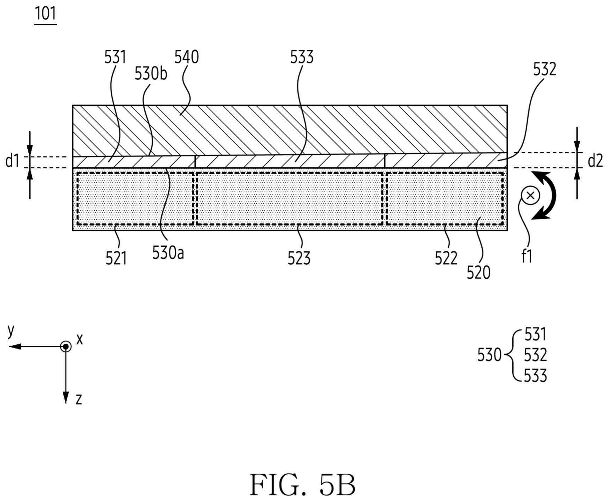

FIG. 5A is a top plan view of an exemplary electronic device in a second state. FIG. 5B is a partial cross-sectional view of an exemplary electronic device cut along line A-A' of FIG. 5A.

Referring to FIGS. 5A and 5B, an electronic device 101 may include a camera 510 (e.g., the camera module 180 of FIG. 1), a flexible display 520 (e.g., the display 230 of FIG. 2A), an adhesive layer 530, and a protection film 540.

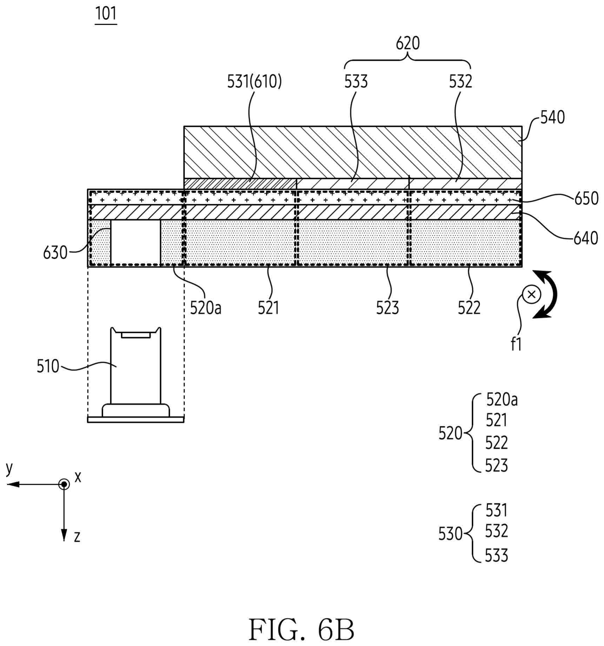

According to an embodiment, at least a portion of the camera 510 may be disposed in the electronic device 101. For example, the camera 510 may be disposed under the flexible display 520. The camera 510 may be disposed under the flexible display 520 thereby being disposed in the electronic device 101. The at least a portion of the camera 510 may be covered by the flexible display 520. The at least a portion of the camera 510 may not be exposed to an outside by the flexible display 520. For example, the at least a portion of the camera 510 may not be fully covered by the flexible display 520. However, since a portion (e.g., a portion configured to allow light to enter a camera lens) for receiving light of the camera 510 needs to allow light to transmit and/or go through, a region for receiving light of the camera 510 may be implemented in the flexible display 520 and/or the electronic device 101 in a form such as a hole, a display cutout, a punch hole, or a UDC pixel, and may include any structure formed to receive light for capturing. The camera 510 may be referred to as an under display camera (UDC) in terms of being positioned under the flexible display 520. For example, the flexible display 520 may include an opening (e.g., a camera hole 630 of FIG. 6B). When viewing the flexible display 520 from above, the at least a portion of the camera 510 may be disposed to be at least partially overlapped or aligned with the opening. The camera 510 may be referred to as a punch hole camera in terms of the at least the portion of the camera being overlapped with the opening. For example, the camera 510 may obtain an image corresponding to a direction in which the flexible display faces through at least a portion (e.g., a transmission region 520a) of the flexible display 520. For example, the camera 510 may be referred to as a front camera of a camera module (e.g., the camera module 180 of FIG. 1) of the electronic device 101 in terms of obtaining the image corresponding to the direction in which the flexible display 520 faces. However, it is not limited thereto. According to an embodiment, it may include one or more lenses, an image sensor (e.g., the first image sensor 250-1 of FIG. 2A), and/or an image signal processor.

According to an embodiment, the flexible display 520 may include the transmission region 520a for receiving light of the camera 510, a first region 521 surrounding the transmission region 520a, and a second region 522 that is deformable.

For example, the transmission region 520a may be a region where the camera 510 is positioned when viewing the flexible display 520 from above (e.g., when viewing in a +z direction). For example, the transmission region 520a may be a region overlapped with the camera 510 when viewing the flexible display 520 from above. For example, the camera 510 may be disposed on a printed circuit board in the electronic device 101. The camera 510 may be mounted on a surface of the printed circuit board facing the flexible display 520. The transmission region 520a may be a region disposed on a portion of the printed circuit board on which the camera 510 is mounted. For example, the transmission region 520a may be a region of the flexible display 520 facing the camera 510. For example, the transmission region 520a may be a region disposed on the camera 510. For example, the transmission region 520a may be a region disposed over the camera 510. For example, the transmission region 520a may be an inflow path of light transmitted to the camera 510 from an outside of the electronic device 101. For example, the transmission region 520a may be a window for obtaining an image corresponding to a direction in which the camera 510 faces the flexible display 520. For example, the flexible display 520 may include a notch that is disposed along an edge of the flexible display 520 and does not provide visual information to a user. The transmission region 520a may be at least a portion of the notch. However, it is not limited thereto.

For example, the first region 521 may be a region in contact with the transmission region 520a. For example, the first region 521 may cover at least a portion of the transmission region 520a. For example, the first region 521 may be a region extending from the transmission region 520a. For example, the first region 521 may be a region of the flexible display 520 closest to the transmission region 520a. For example, the first region 521 may be a region surrounding the camera 510 when viewing the flexible display 520 from above. For example, a boundary between the first region 521 and the transmission region 520a may be a boundary formed by the camera 510 when viewing the flexible display 520 from above.

For example, the second region 522 may be a size-deformable region of the flexible display 520. For example, the second region 522 may be spaced apart from the transmission region 520a. For example, the second region 522 may have flexibility. For example, at least a portion of the second region 522 may be bent according to an operation of the electronic device 101. For example, at least a portion of the second region 522 may be rolled according to an operation of the electronic device 101. For example, the second region 522 may be configured such that a size of the flexible display 520 exposed to the outside of the electronic device 101 is changed. For example, the second region 522 may be referred to as a flexible region in terms of being deformable according to an operation of the electronic device 101, but is not limited thereto.

According to an embodiment, although not illustrated, the flexible display 520 may include a layered structure of two or more layers extending from the first region 521 to the second region 522. For example, the flexible display 520 may include at least one window (e.g., a window 650 of FIG. 6B). As the at least one window is substantially transparent, light may be emitted to the outside of the electronic device 101 by passing the light emitted from the flexible display 520. For example, the flexible display 520 may include a polarizer. The polarizer may reduce an amount of light reflected in the flexible display 310 after being incident from the outside of the electronic device 101. As the amount of the light reflected in the flexible display decreases, visibility of the flexible display 520 may be improved. For example, the flexible display 520 may include a display panel. For example, the flexible display 520 may include a plurality of adhesive layers for attaching layers included in the flexible display 520 to each other. However, it is not limited thereto. The flexible display 520 may include two or more layers layered in the flexible display 520 and distinguished according to functions.

According to an embodiment, the adhesive layer 530 may be disposed on the flexible display 520. For example, the adhesive layer 530 may include a first portion 531 disposed on the first region 521 of the flexible display 520, and a second portion 532 disposed on the second region 522 of the flexible display 520.

For example, the adhesive layer 530 may attach the protection film 540 on the flexible display 520. For example, the adhesive layer 530 may be disposed between the flexible display 520 and the protection film 540. For example, the adhesive layer 530 may be interposed between the flexible display 520 and the protection film 540. For example, the adhesive layer 530 may cover at least a portion of the flexible display 520. For example, the adhesive layer 530 may be layered on the flexible display 520. For example, the adhesive layer 530 may include at least one of a pressure sensitive adhesive (PSA) and an optically clear adhesive (OCA), but is not limited thereto.

For example, the first portion 531 of the adhesive layer 530 may be in contact with the first region 521 of the flexible display 520. For example, the first portion 531 may be attached on the first region 521. For example, the first portion 531 may cover at least a portion of the first region 521. For example, the first portion 531 may be overlapped with at least a portion of the first region 521. For example, the first portion 531 may be disposed between the first region 521 and the protection film 540. For example, the first portion 531 may include a portion facing the transmission region 520a when viewing the flexible display 520 from above. For example, when viewing the flexible display 520 from above, the first portion 531 may include a portion surrounding at least a portion of the transmission region 520a. For example, the first portion 531 may be a portion of the adhesive layer 530 adjacent to the transmission region 520a.

For example, the second portion 532 of the adhesive layer 530 may be in contact with the second region 522 of the flexible display 520. For example, the second portion 532 may be attached on the second region 522. For example, the second portion 532 may cover at least a portion of the second region 522. For example, the second portion 532 may be overlapped with the at least a portion of the second region 522. For example, the second portion 532 may be disposed between the second region 522 and the protection film 540. For example, the second portion 532 may include a portion facing the first region 521 when viewing the flexible display 520 from above. For example, the second portion 532 may be deformed according to deformation of the second region 522 by being disposed on the second region 522. For example, at least a portion of the second portion 532 may be bent with a curvature according to an operation of the electronic device 101. For example, as the second region 522 is deformed, the second portion 532 may be pressed.

For example, the second portion 532 may be at least partially deformed as the second region 522 is deformed, thereby pressing the first portion 531 toward the transmission region 520a when viewing the flexible display 520 from above. For example, since the first portion 531 and the second portion 532 form the adhesive layer 530, the first portion 531 may be pressed toward the transmission region 520a as the second portion 532 is pressed by the second region 522 of the flexible display 520. As the first portion 531 is pressed, at least a portion of an adhesive material included in the adhesive layer 530 may flow into the transmission region 520a. The electronic device 101 may require a structure to reduce pollution of the transmission region 520a due to the inflow of the adhesive material from the adhesive layer 530 under the protection film 540 to the transmission region 520a for receiving light of the camera 510.

According to an embodiment, the flexible display 520 may further include a third region 523 connecting the first region 521 and the second region 522. The adhesive layer 530 may further include a third portion 533 extending from the first portion 531 to the second portion 532 and disposed on the third region 523. For example, the third region 523 may extend from the first region 521 to the second region 522. For example, the third region 523 may be disposed between the first region 521 and the second region 522. For example, the transmission region 520a, the first region 521, and the third region 523 may be regions exposed to the outside of the electronic device 101. For example, the transmission region 520a, the first region 521, and the third region 523 may be regions that are not deformable unlike the second region 522. The transmission region 520a, the first region 521, and the third region 523 may be referred to as a rigid region of the flexible display 520, but are not limited thereto.

For example, the third portion 533 of the adhesive layer 530 may connect the first portion 531 and the second portion 532. For example, the third portion 533 may be disposed between the first portion 531 and the second portion 532. For example, the third portion 533 may be in contact with the third region 523 of the flexible display 520. For example, the third portion 533 may be attached on the third region 523. For example, the third portion 533 may cover at least a portion of the third region 523. For example, the third portion 533 may be overlapped with the at least a portion of the third region 523. For example, the third portion 533 may be disposed between the third region 523 and the protection film 540.

According to an embodiment, unlike as illustrated, the third region 523 and the third portion 533 disposed on the third region 523 may be omitted. In this case, the first region 521 may be in contact with the second region 522. The first portion 531 disposed on the first region 521 may be in contact with the second portion 532 disposed on the second region 522.

According to an embodiment, the protection film 540 may be disposed on the adhesive layer 530. For example, the protection film 540 may be attached on the flexible display 520 through the adhesive layer 530. For example, the protection film 540 may be overlapped with the adhesive layer 530. For example, the protection film 540 may be in contact with the adhesive layer 530. For example, the protection film 540 may be spaced apart from the flexible display 520 by the adhesive layer 530. For example, the protection film 540 may cover at least a portion of the flexible display 520. For example, the protection film 540 may be disposed on a portion of the flexible display 520 configured to display visual information to the user. For example, a remaining portion of the flexible display 520 not covered by the protection film 540 may be a notch that does not provide visual information to the user. For example, when viewing the flexible display 520 from above, the protection film 540 may include a portion surrounding the transmission region 520a of the flexible display 520. For example, the protection film 540 may include a portion that is deformed according to deformation of the second region 522 by being disposed on the second region 522 that is deformable. The electronic device 101 may include the protection film 540 attached on the flexible display 520 by the adhesive layer 530, thereby reducing damage to the flexible display 520 by an external impact.

According to an embodiment, a thickness d1 of the first portion 531 may be smaller than a thickness d2 of the second portion 532. For example, a length d1 of the first portion 531 extending from the first region 521 to the protection film 540 may be less than a length d2 of the second portion 532 extending from the second region 522 to the protection film 540. For example, a gap between the first region 521 for accommodating the first portion 531 and a protection film 540 may be smaller than a gap between the second region 522 for accommodating the second portion 532 and the protection film 540. For example, an average thickness d1 of an adhesive material included in the first portion 531 may be smaller than an average thickness d2 of an adhesive material included in the second portion 532.

For example, the adhesive layer 530 may include a first surface 530a in contact with a surface of the flexible display 520 facing the protection film 540, and a second surface 530b opposite the first surface 530a and in contact with a surface of the protection film 540 facing the flexible display. The second surface 530b may be inclined with respect to the first surface 530a. As the second surface 530b is inclined with respect to the first surface 530a, the thickness d1 of the first portion 531 may be smaller than the thickness d2 of the second portion 532.

For example, in a case that the adhesive layer 530 includes the third portion 533 extending from the first portion 531 to the second portion 532, the first portion 531, the second portion 532, and the third portion 533 may form the continuous first surface 530a and the second surface 530b opposite the first surface 530a. The second surface 530b may be inclined with respect to the first surface 530a. As the second surface 530b being inclined with respect to the first surface 530a, a thickness of the adhesive layer 530 may be reduced in a direction (e.g., a +y direction) from the second portion 532, through the third portion 533, toward the first portion 531, in the adhesive later 530.

For example, in a case that the third portion 533 between the first portion 531 and the second portion 532 in the adhesive layer 530 is omitted, unlike as illustrated, the first portion 531 may extend from the second portion 532. The first portion 531 and the second portion 532 may form the continuous first surface 530a and the second surface 530b opposite the first surface 530a. The second surface 530b may be inclined with respect to the first surface 530a. As the second surface 530b being inclined with respect to the first surface 530a, a thickness of the adhesive layer 530 may be reduced in a direction (e.g., the + y direction) from the second portion 532 toward the first portion 531 in the adhesive layer 530.

For example, the first portion 531 and the second portion 532 may be formed of substantially the same adhesive. An amount of the adhesive included in the first portion 531 may be smaller than an amount of the adhesive included in the second portion 532. For example, an amount of the adhesive per unit volume included in the first portion 531 may be smaller than an amount of the adhesive per unit volume included in the second portion 532. For example, when cutting the adhesive layer 530 based on an yz plane, an area of the adhesive included in the first portion 531 may be smaller than an area of the adhesive included in the second portion 532. An amount of the adhesive per unit area included in the first portion 531 may be smaller than an amount of the adhesive per unit area included in the second portion 532. For example, an amount of an adhesive per unit length included in the first portion 531 based on a z-axis may be less than an amount of an adhesive per unit length included in the second portion 532.

According to an embodiment, the electronic device 101 may further include a first housing 210, and a second housing 220, movable relative to the first housing 210, in which the transmission region 520a of the flexible display 520 and the first region 521 are disposed. For example, at least a portion of the second region 522 of the flexible display 520 and at least a portion of the second portion 532 of the adhesive layer 530 may be configured to be rolled into the first housing 210 or exposed to an outside of the first housing 210, according to movement of the second housing 220 relative to the first housing 210. For example, the transmission region 520a and the first region 521 of the flexible display 520 may be disposed on the second housing 220. For example, at least a portion of the second region 522 that is deformable may be disposed in the first housing 210 or exposed to the outside of the first housing 210, according to the movement of the second housing 220 relative to the first housing 210. For example, the second portion 532 of the adhesive layer 530 disposed on the second region 522, and at least a portion of the protection film 540 disposed on the second portion 532, may be disposed in the first housing 210 or exposed to the outside of the first housing 210 along the second region 522.

According to an embodiment, the first housing 210 may be configured to provide a first folding axis f1 in which the second region 522 of the flexible display 520 is bent with a curvature. The second housing 220 may be configured to be movable relative to the first housing 210 in a first direction 261 and a second direction 262 opposite to the first direction 261. For example, the transmission region 520a of the flexible display 520 may be disposed along a first edge 221 of the second housing 220 facing the first folding axis f1.

For example, when referring to FIGS. 2A to 2D together, while the electronic device 101 is changed from a first state to a second state, along the second housing 220 moving in the first direction 261, the second region 522 may be deformed such that a size of the flexible display 520 exposed to the outside of the first housing 210 increases. While the electronic device 101 is changed from the second state to the first state, along the second housing 220 moving in the second direction 262 opposite to the first direction 261, the second region 522 may be deformed such that the size of the flexible display 520 exposed to the outside of the first housing 220 is reduced. The second portion 532 of the adhesive layer 530 disposed on the second region 522 and at least a portion of the protection film 540 disposed on the second portion 532 may be deformed along the second region 522 that is deformed by the movement of the second housing 220.

For example, when referring to FIGS. 4A and 4B together, at least a portion of the second region 522 may be bent with a curvature based on the first folding axis f1. The at least a portion of the second region 522 of the adhesive layer 530 on the second region 522 may be bent by the second region 522 that is bent. As the at least portion of the second region 522 is bent, the adhesive layer 530 may be pressed in the direction (e.g., the +y direction or the first direction 261) from the second portion 532 toward the first portion 531.

For example, the first region 521 of the flexible display 520 may be in contact with the first edge 221 of the second housing 220 facing the first folding axis f1. For example, the transmission region 520a at least partially surrounded by the first region 521 may be disposed adjacent to the first edge 221. The second portion 532 of the adhesive layer 530 disposed on the second region 522 along the second region 522 deformed based on the first folding axis f1 may be pressed. As the at least portion of the second region 522 is bent, the adhesive layer 530 may be pressed in the direction (e.g., the +y direction or the first direction 261) from the second region 522 toward the first portion 531 disposed on the first region 521. As the thickness d1 of the first portion 531 is smaller than the thickness d2 of the second portion 532, the adhesive layer 530 may reduce an inflow of an adhesive material from the first portion 531 to the transmission region 520a. As the thickness d2 of the second portion 532 is greater than the thickness d1 of the first portion 531, the adhesive layer 530 may reduce peeling of the protection film 540 on the second portion 532 according to deformation of the second portion 532.

The electronic device 101 according to the above-described embodiment may reduce damage to the flexible display 520 due to an external impact by including the protection film 540. As the thickness d1 of the first portion 531 disposed on the first region 521 of the flexible display 520 smaller than the thickness d2 of the second portion 532 disposed on the second region 522 of the flexible display 520 that is deformable, the adhesive layer 530 disposed between the flexible display 520 and the protection film may reduce the inflow of the adhesive material from the first portion 531 to the transmission region 520a and preserve visibility of the camera 510.

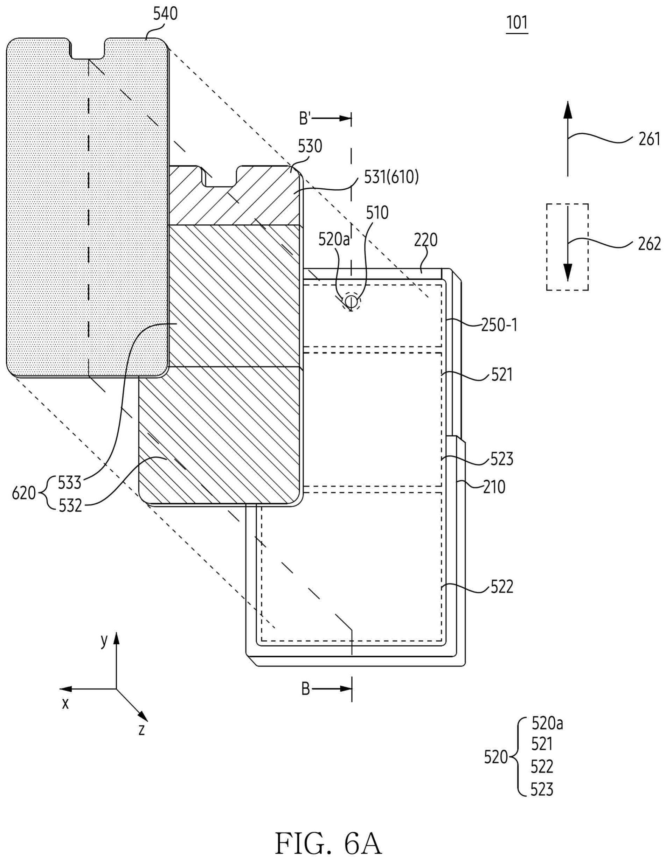

FIG. 6A is a partially exploded perspective view of an exemplary electronic device in a second state. FIG. 6B is a partial cross-sectional view of an exemplary electronic device cut along line B-B' of FIG. 6A.

Referring to FIGS. 6A and 6B, an electronic device 101 may include a camera 510. The electronic device 101 may include a flexible display 520 including a transmission region 520a for receiving light of the camera 510, a first region 521 surrounding the transmission region 520a, and a second region 522 that is deformable. The electronic device 101 may include an adhesive layer 530 on the flexible display 520 including a first portion 531 disposed on the first region 521 and a second portion 532 disposed on the second region 522. The electronic device 101 may include a protection film 540 disposed on the adhesive layer 530. According to an embodiment, the electronic device 101 may further include a first housing 210 that provides a first folding axis f1, and a second housing 220 that is movable relative to the first housing 210 in a first direction 261 and a second direction 262 opposite to the first direction 261.

Hereinafter, an overlapping description of the configuration described in FIGS. 5A and 5B will be omitted.

According to an embodiment, a property of the first portion 531 of the adhesive layer 530 may be different from a property of the second portion 532 of the adhesive layer 530 in order to reduce an inflow of an adhesive material from the first portion 531 to the transmission region 520a of the flexible display 520. Since the property of the first portion 531 being different from the property of the second portion 532 may include at least one or more of a cohesion, a peel strength, a creep resistance, a rigidity, a hardness, a modulus, an adhesion, and a thickness, it should be noted that it is not limited to properties mentioned in the present document. For example, a rigidity of the first portion 531 may be greater than a rigidity of the second portion 532. For example, a hardness of the first portion 531 may be greater than a hardness of the second portion 532. For example, a modulus of the first portion 531 may be greater than a modulus of the second portion 532. For example, an adhesion of the first portion 531 may be greater than an adhesion of the second portion 532. For example, a creep resistance of the first portion 531 may be greater than a creep resistance of the second portion 532. Since the property of the first portion 531 is different from the property of the second portion 532, the adhesive layer 530 may reduce the inflow of the adhesive material from the first portion 531 to the transmission region 520a of the flexible display 520 and increase an adhesion between the adhesive layer 530 and the protection film 540.

According to an embodiment, the adhesive layer 530 may further include a first adhesive 610 forming the first portion 531 and a second adhesive 620 forming the second portion 532. An adhesion of the first adhesive 610 may be greater than an adhesion of the second adhesive 620. For example, a cohesion of the first adhesive 610 may be greater than a cohesion of the second adhesive 620. For example, a peel strength between the first adhesive 610 and the first region 521 may be greater than a peel strength between the second adhesive 620 and the second region 522. For example, a peel strength between the first adhesive 610 and the protection film 540 may be greater than a peel strength between the second adhesive 620 and the protection film 540. For example, a creep resistance of the first adhesive 610 may be greater than a creep resistance of the second adhesive 620. As the adhesion of the first adhesive 610 forming the first portion 531 is greater than the adhesion of the second adhesive 620 forming the second portion 532, the adhesive layer 530 may reduce the inflow of the adhesive material from the first portion 531 to the transmission region 520a of the flexible display 520 and increase the adhesion between the adhesive layer 530 and the protection film 540.

According to an embodiment, the flexible display 520 may further include a third region 523 connecting the first region 521 and the second region 522. The adhesive layer 530 may further include a third portion 533 on the third region 523 extending from the first portion 531 to the second portion 532. The adhesive layer 530 may further include a first adhesive 610 forming the first portion 531, and a second adhesive 620 forming the second portion 532 and the third portion 533. An adhesion of the first adhesive 610 may be greater than an adhesion of the second adhesive 620.

According to an embodiment, the transmission region 520a of the flexible display 520 may include a camera hole 630 exposing at least a portion of the camera 510. For example, the camera hole 630 may be formed in at least a portion of the transmission region 520a. For example, the camera hole 630 may penetrate the at least a portion of the transmission region 520a. For example, the camera hole 630 may face the camera 510. For example, the camera hole 630 may expose at least a portion (e.g., a lens) of the camera 510 to be visible from an outside of the electronic device 101. The camera 510 at least partially positioned in the camera hole 630 may be referred to as a punch hole camera, but is not limited thereto. The flexible display 520 may reduce an unnecessary notch region of the flexible display 520 by including the camera hole 630 for the camera 510 in the transmission region 520a.

**It** has been described that the transmission region 520a includes the camera hole 630, but is not limited thereto. For example, instead of the camera hole 630, the transmission region 520a may include a pixel region for an under display camera (UDC camera). The pixel region may have a lower pixel density than another pixel region distinguished from the pixel region of the flexible display 520 for receiving light of the camera 510. However, it is not limited thereto.

According to an embodiment, the flexible display 520 may further include a window 640 and an anti fingerprint layer 650 layered on the window 640 and in contact with the adhesive layer 530. For example, the window 640 may include at least one of acrylic, elastomer, glass, and polyimide, but is not limited thereto. For example, the anti fingerprint layer 650 may be disposed between the window 640 and the adhesive layer 530. The flexible display 520 may reduce formation of stains on the flexible display 520 by including the anti fingerprint layer 650 on the window 640.

According to the above-described embodiment, the electronic device 101 may reduce peeling of the protection film 540 from the flexible display 520 by including the adhesive layer 530 having a different property according to a region of the flexible display 520. Since the property of the first portion 531 of the adhesive layer 530 is different from the property of the second portion 532 of the adhesive layer 530, the adhesive layer 530 may reduce the inflow of the adhesive material from the first portion 531 to the transmission region 520a of the flexible display 520 and increase the adhesion between the adhesive layer 530 and the protection film 540.

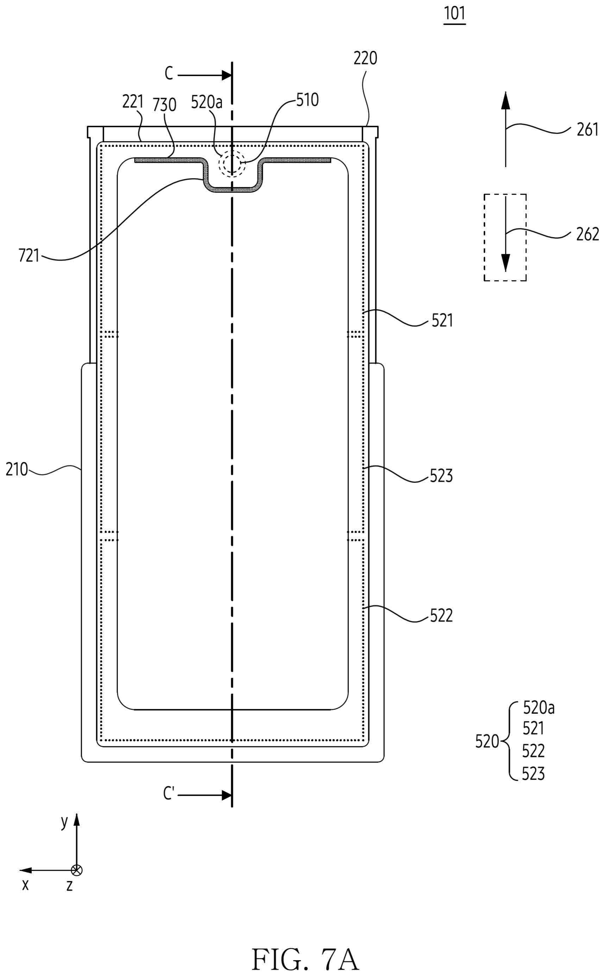

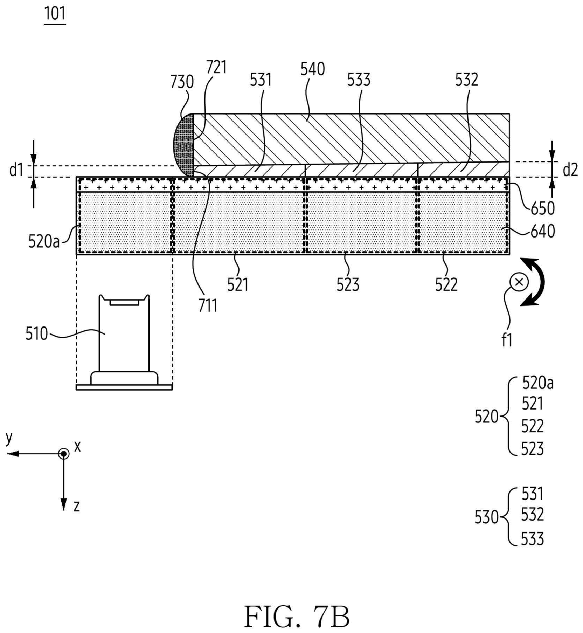

FIG. 7A is a top plan view of an exemplary electronic device in an exemplary second state. FIG. 7B is a partial cross-sectional view of an exemplary electronic device cut along line C-C' of FIG. 7A.

Referring to FIGS. 7A and 7B, an electronic device 101 may include a camera 510. The electronic device 101 may include a flexible display 520 including a transmission region 520a for receiving light of the camera 510, a first region 521 surrounding the transmission region 520a, and a second region 522 that is deformable. The electronic device 101 may include an adhesive layer 530 on the flexible display 520 including a first portion 531 disposed on the first region 521 and a second portion 532 disposed on the second region 522. The electronic device 101 may include a protection film 540 disposed on the adhesive layer 530. According to an embodiment, a thickness d1 of the first portion 531 may be equal to or smaller than a thickness d2 of the second portion 532. According to an embodiment, the electronic device 101 may further include a first housing 210 that provides a first folding axis f1, and a second housing 220 that is movable relative to the first housing 210 in a first direction 261 and a second direction 262 opposite to the first direction 261.

According to an embodiment, the first portion 531 of the adhesive layer 530 may include a first side surface 711 surrounding at least a portion of the transmission region 520a when viewing the flexible display 520 from above. The protection film 540 may include a second side surface 721 extending from the first side surface 711 and surrounding at least a portion of the transmission region 520a when viewing the flexible display 520 from above.

For example, the first side surface 711 may be a surface of the adhesive layer 530 facing the transmission region 520a when viewing the flexible display 520 from above. For example, the first side surface 711 may be a surface of the adhesive layer 530 surrounding the at least a portion of the transmission region 520a. For example, the second side surface 721 may be a surface of the protection film 540 facing the transmission region 520a when viewing the flexible display 520 from above. For example, the second side surface 721 may be a surface of the protection film 540 surrounding at least a portion of the transmission region 520a. For example, the second side surface 721 may be disposed on a boundary between the first region 521 and the transmission region 520a of the flexible display 520. For example, the first side surface 711 may extend from the second side surface 721 to the flexible display 520. For example, the first side surface 711 may extend from the second side surface 721 to the first region 521. For example, the first side surface 711 and the second side surface 721 may be at least a portion of a side surface of the adhesive layer 530 corresponding to a first edge 221 of the second housing 220 adjacent to the transmission region 520a or at least a portion of a side surface of the protection film 540.

According to an embodiment, the electronic device 101 may further include a coating member 730 sealing the first side surface 711 of the adhesive layer 530 by extending from the second side surface 721 of the protection film 540 to the first region 521 of the flexible display 520.

For example, the coating member 730 may be disposed along the second side surface 721. For example, the coating member 730 may be in contact with at least a portion of the second side surface 721. For example, the coating member 730 may be attached on at least a portion of the second side surface 721 and the first region 521. For example, the coating member 730 may cover the first side surface 711. For example, the coating member 730 may face the first side surface 711. For example, the coating member 730 may be in contact with the first side surface 711 extending from the second side surface 721. For example, the coating member 730 may separate the first side surface 711 of the first portion 531 from the transmission region 520a in order to reduce an inflow of an adhesive material from the first portion 531 to the transmission region 520a. For example, the coating member 730 may reduce the inflow of the adhesive material from the first portion 531 to the transmission region 520a by pressing the first side surface 711, which is pressed in a direction (e.g., a +y direction or the first direction 261) from the second portion 532 toward the first portion 531 due to deformation of the flexible display 520, in a direction (e.g., a -y direction or the second direction 262) opposite to the direction. For example, the coating member 730 may include at least one of acrylic, elastomer, and urethane, but is not limited thereto.

According to the above-described embodiment, the electronic device 101 may prevent leakage of the adhesive material from the adhesive layer 530 and reduce the inflow of the adhesive material from the first portion 531 of the adhesive layer 530 to the transmission region 520a of the flexible display 520 by including the coating member 730.

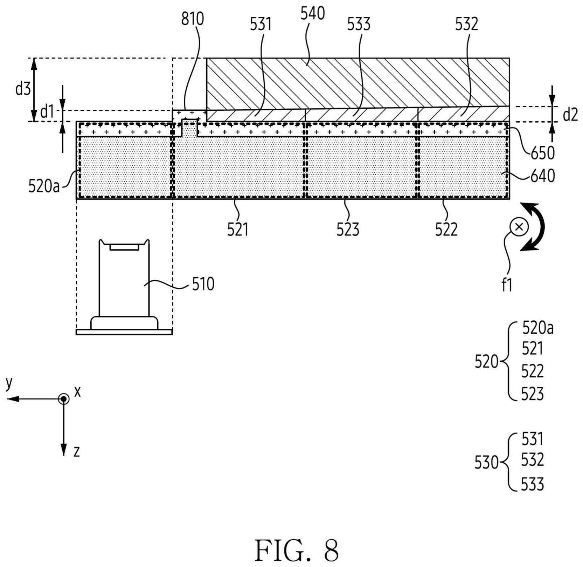

FIG. 8 is a partial cross-sectional view of an exemplary electronic device.

Referring to FIG. 8, an electronic device 101 may include a camera 510. The electronic device 101 may include a flexible display 520 including a transmission region 520a for receiving light of the camera 510, a first region 521 surrounding the transmission region 520a, and a second region 522 that is deformable. The electronic device 101 may include an adhesive layer 530 on the flexible display 520 including a first portion 531 disposed on the first region 521 and a second portion 532 disposed on the second region 522. The electronic device 101 may include a protection film 540 disposed on the adhesive layer 530. According to an embodiment, a thickness d1 of the first portion 531 may be equal to or smaller than a thickness d2 of the second portion 532.

According to an embodiment, the flexible display 520 may further include a protrusion 810 protruding from the first region 521 and at least partially facing the first portion 531 of the adhesive layer 530 in order to reduce an inflow of an adhesive material from the adhesive layer 530 to the transmission region 520a. For example, the protrusion 810 may seal the first portion 531 of the adhesive layer 530 by protruding from the first region 521. For example, the protrusion 810 may be formed along a boundary between the transmission region 520a and the first region 521 of the flexible display 520. For example, when viewing the flexible display 520 from above, the protrusion 810 may cover a first side surface (e.g., the first side surface 711 of FIG. 7B) of the first portion 531 surrounding at least a portion of the transmission region 520a. The protrusion 810 may be in contact with the first side surface 711. For example, a length of the protrusion 810 protruding from the first region 521 in a direction (e.g., a -z direction) in which the first region 521 faces may be substantially the same as the thickness d1 of the first portion 531. By including the protrusion 810, the flexible display 520 may reduce the inflow of the adhesive material from the first portion 531 to the transmission region 520a.

According to an embodiment, a total thickness d3 of the adhesive layer 530 and the protection film 540 may be substantially the same. For example, the length of the protrusion 810 of the flexible display 520 may be substantially the same as the total thickness of the adhesive layer 530 and the protection film 540. For example, since the thickness d1 of the first portion 531 is smaller than the thickness d2 of the second portion 532, a thickness of the protection film 540 disposed on the first portion 531 may be greater than a thickness of the protection film 540 disposed on the second portion 532, in order to maintain the total thickness d3 of the adhesive layer 530 and the protection film 540 as a constant thickness. The length of the protrusion 810 protruding from the first region 521 in the direction (e.g., the -z direction) in which the first region 521 faces may be substantially the same as the total thickness d3 of the adhesive layer 530 and the protection film 540. For example, when viewing the flexible display 520 from above, the protrusion 810 may face a second side surface (e.g., the second side surface 721 of FIG. 7A) of the protection film 540 surrounding at least a portion of the transmission region 520a. The protection film 540 may separate the first side surface 711 of the first portion 531 extending from the second side surface 721 from the transmission region 520a by being in contact with the second side surface 721.

According to the above-described embodiment, the flexible display 520 prevent leakage of an adhesive material from the adhesive layer 530 and reduce the inflow of the adhesive material from the first portion 531 of the adhesive layer 530 to the transmission region 520a of the flexible display 520 by including the protrusion 810.

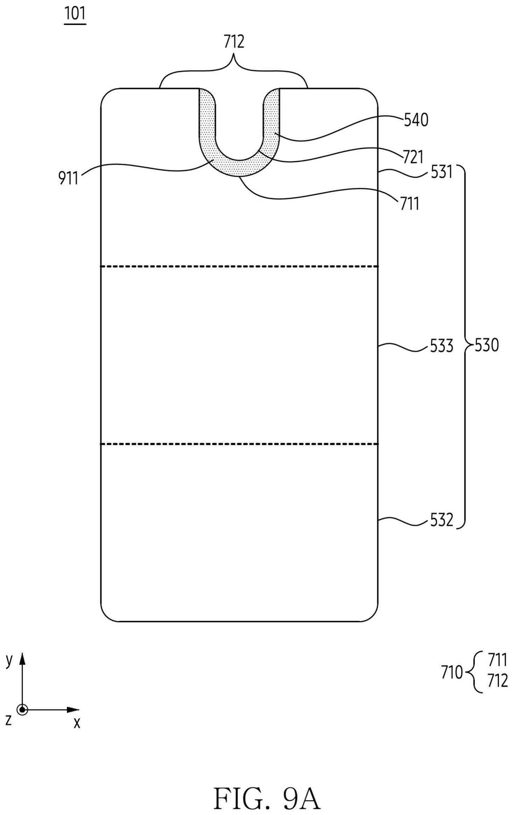

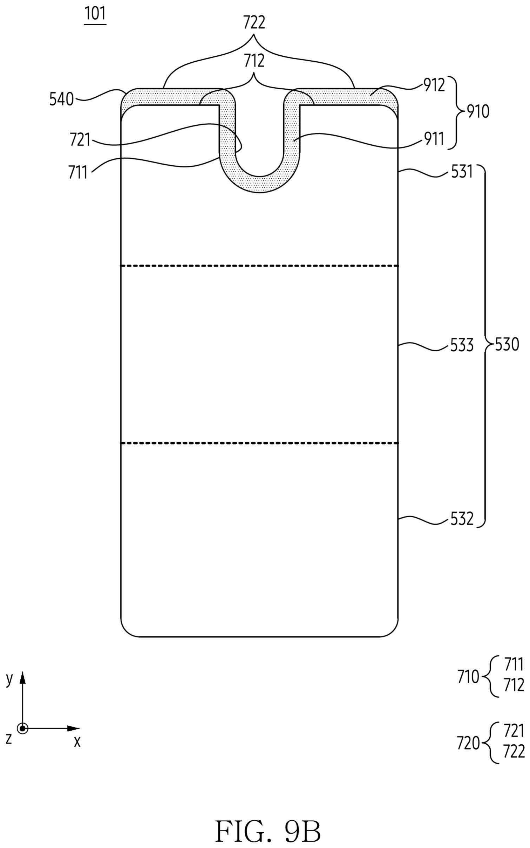

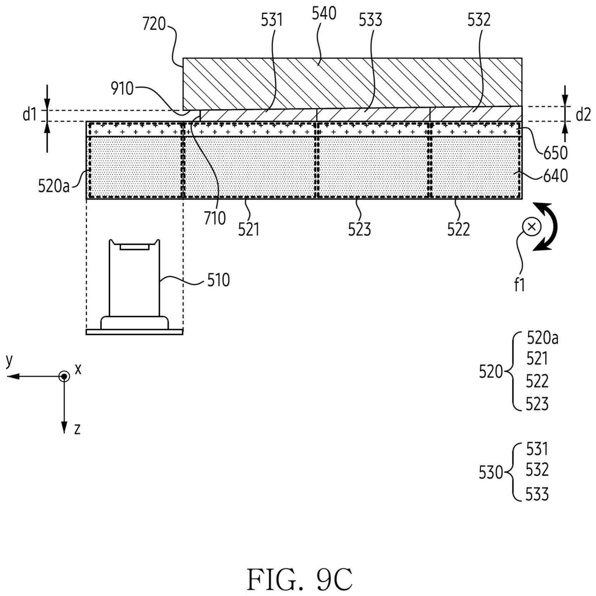

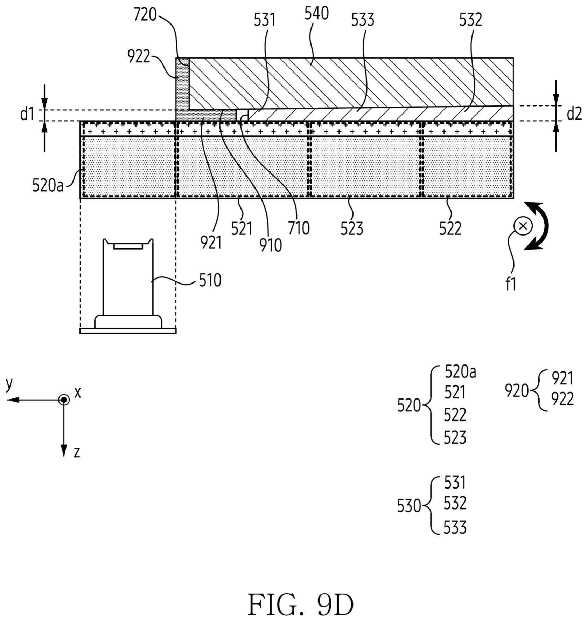

FIGS. 9A and 9B illustrate a protection film and an adhesive layer of an exemplary electronic device. FIGS. 9C and 9D are partial cross-sectional views of an exemplary electronic device.

Referring to FIGS. 9A, 9B, and 9C, an electronic device 101 may include a camera 510. The electronic device 101 may include a flexible display 520 including a transmission region 520a for receiving light of the camera 510, a first region 521 surrounding the transmission region 520a, and a second region 522 that is deformable. The electronic device 101 may include an adhesive layer 530 on the flexible display 520 including a first portion 531 disposed on the first region 521 and a second portion 532 disposed on the second region 522. The electronic device 101 may include a protection film 540 disposed on the adhesive layer 530. According to an embodiment, a thickness d1 of the first portion 531 may be equal to or smaller than a thickness d2 of the second portion 532.

According to an embodiment, the first portion 531 may include a first side portion 711 including a first side surface 711 surrounding at least a portion of the transmission region 520a when viewing the flexible display 520 from above and a third side surface 712 extending from the first side surface 711. The protection film 540 may include a second side portion 720 including a second side surface 721 surrounding the transmission region 520a when viewing the flexible display 520 from above a fourth side surface 722 extending from the second side surface 721. According to an embodiment, in order to reduce an inflow of an adhesive material from the adhesive layer 530 to the transmission region 520a, a step 910 may be formed in the first side portion 710 with respect to the second side portion 720. According to an embodiment, the step 910 may include a first step portion 911 formed on the first side surface 711, and a second step portion 912 contacting the first step portion 911 and formed on the third side surface 712.

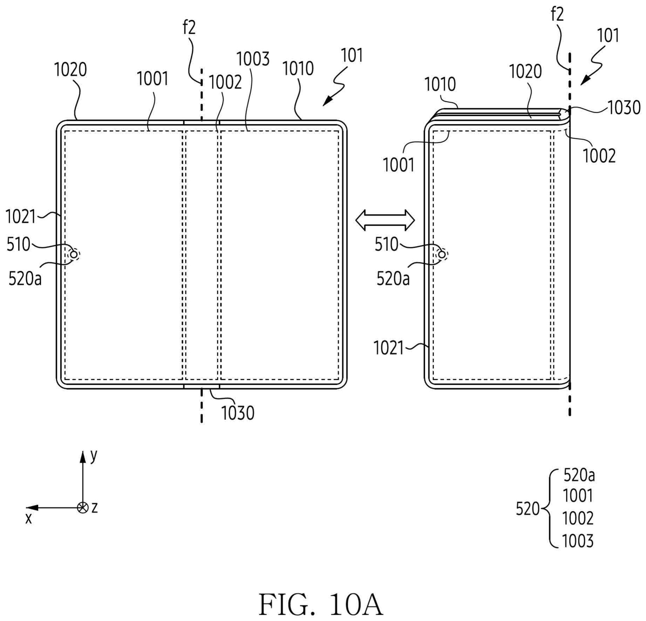

For example, the first side portion 710 may be a portion of a periphery of the adhesive layer 530 adjacent to the transmission region 520a. For example, the second side portion 720 may be a portion of the periphery of the protection film 540 adjacent to the transmission region 520a. The second side portion 720 may be disposed over the first side portion 710 of the adhesive layer 530. For example, when referring to FIG. 5A together, the first side portion 710 and the second side portion 720 may be disposed along a first edge 221 of a second housing 220 facing a first folding axis f1. For example, when referring to FIG. 10A together, the first side portion 710 and the second side portion 720 may be disposed along a second edge 1021 of a fourth housing 1020 facing a second folding axis f2.

For example, the step 910 may be a structure in which the first side portion 710 of the adhesive layer 530 is dent relative to the second side portion 720 of the protection film 540 when viewing the protection film 540 from above. For example, when viewing the protection film 540 from above, the step 910 may have a structure in which the adhesive layer 530 is not disposed between the protection film 540 and the flexible display 520. For example, the step 910 may have a structure in which an adhesive material of the adhesive layer 530 is not disposed under the protection film 540. For example, the step 910 may be a structure formed as at least a portion of the first side portion 710 of the adhesive layer 530 has an offset with respect to the second side portion 720 of the protection film 540. For example, the electronic device 101 may have a groove structure formed by the first region 521 of the flexible display 520, at least a portion of the first side portion 710, and the step 910.

For example, referring to FIG. 9A, the second side surface 721 may have a first step portion 911 with respect to the first side surface 711. The first side surface 711 may be dent with respect to the second side surface 721. The fourth side surface 722 may extend from the third side surface 712. For example, referring to FIG. 9B, the fourth side surface 722 may have a second step portion 912 with respect to the third side surface 712. The third side surface 712 may be dent with respect to the fourth side surface 722. As the second side portion 720 has the step 910 with respect to the first side portion 710, the electronic device 101 may prevent leakage of an adhesive material from the adhesive layer 530 and reduce an inflow of the adhesive material from the first portion 531 of the adhesive layer 530 to the transmission region 520a of the flexible display 520.

Referring to FIG. 9D, according to an embodiment, the electronic device 101 may further include a mold member 920 contacting the step 910 and the first region 521 and sealing the first side portion 710. For example, at least a portion of the mold member 920 may face the first side portion 710. For example, the at least a portion of the mold member 920 may be disposed in a portion where the step 910 is formed. For example, the at least a portion of the mold member 920 may be disposed between the protection film 540 and the first region 521 of the flexible display 520 by filling a space where the step 910 is formed. For example, the mold member 920 may be disposed on at least a portion of the second side portion 720 of the protection film 540. For example, the mold member 920 may be formed through UV molding, but is not limited thereto.

For example, the mold member 920 may include a first mold portion 921 facing the first side portion 710, and/or a second mold portion 922, contacting the second side portion 720 and contacting the first mold portion 921. For example, the first mold portion 921 may be positioned in the groove structure of the electronic device 101 formed by the step 910. For example, the first mold portion 921 may extend from a surface of the protection film 540 facing the flexible display 520 to a surface of the first region 521 facing the protection film 540. For example, the second mold portion 922 may extend from the second side portion 720 to the first region 521. For example, the second mold portion 922 may be disposed on at least a portion of the second side portion 720 of the protection film 540. By including the mold member 920, the electronic device 101 may prevent the leakage of the adhesive material from the adhesive layer 530 and reduce the inflow of the adhesive material from the first portion 531 of the adhesive layer 530 to the transmission region 520a of the flexible display 520.

According to the above-described embodiment, the electronic device 101 may reduce the inflow of the adhesive material from the first portion 531 of the adhesive layer 530 to the transmission region 520a of the flexible display 520 by including the protection film 540 having the step 910 with respect to the adhesive layer 530. By including the step 910 and the mold member 920 contacting with the first region 521, the electronic device 101 may prevent the leakage of the adhesive material from the adhesive layer 530 and reduce the inflow of the adhesive material from the first portion 531 of the adhesive layer 530 to the transmission region 520a of the flexible display 520.

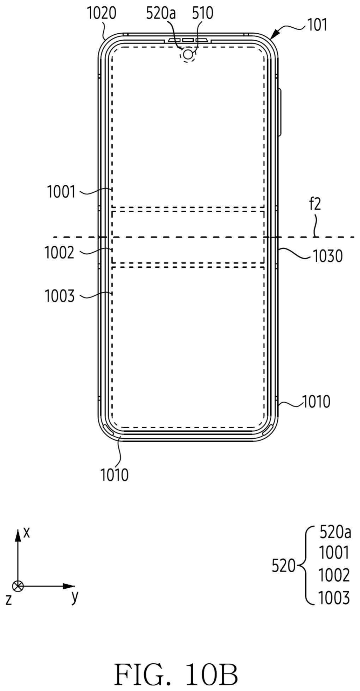

FIGS. 10A and 10B illustrate an exemplary electronic device.

Referring to FIGS. 10A and 10B, an electronic device 101 may include a camera 510. The electronic device 101 may include a flexible display 520 including a transmission region 520a for receiving light of the camera 510, a first region 1001 surrounding the transmission region 520a, and a second region 1002 that is deformable. The electronic device 101 may include an adhesive layer (e.g., the adhesive layer 530 of FIG. 5B) on the flexible display 520, including a first portion (e.g., the first portion 531 of FIG. 5B) disposed on the first region 1001 and a second portion (e.g., the second portion 532 of FIG. 5B) disposed on the second region 1002. The electronic device 101 may include a protection film (e.g., the protection film 540 of FIG. 5A) disposed on the adhesive layer 530. According to an embodiment, a thickness (e.g., the d1 of FIG. 5B) of the first portion 531 may be smaller than a thickness (e.g., the d2 of FIG. 5B) of the second portion 532.

According to an embodiment, the electronic device 101 may further include a third housing 1010, a fourth housing 1020 on which the transmission region 520a and the first region 1001 are disposed, and a hinge structure 1030 rotatably connecting the third housing 1010 and the fourth housing 1020 and disposed under the second region 1002. According to an embodiment, the transmission region 520a and the first region 1001 of the flexible display 520 may be disposed on the fourth housing 1020. The second region 1002 of the flexible display 520 may be disposed on the hinge structure 1030. The flexible display 520 may further include a third region 1003 disposed on the third housing 1010.

An unfolded state of the electronic device 101 may be a state in which the first region 1001 and the third region 1003 face the same direction (e.g., a -z direction). The unfolded state may be a state in which the first region 1001, the second region 1002, and the third region 1003 substantially form a plane. A folded state of the electronic device 101 may be a state in which a direction (e.g., the -z direction) in which the first region 1001 faces is opposite to a direction (e.g., a +z direction) in which the third region 1003 faces. The folded state may be a state in which deformation of the second region 1002 is maximized.

For example, the second portion 532 of the adhesive layer 530 disposed on the hinge structure 1030 may be pressed by the second region 1002 deformed while the electronic device 101 is changed from the unfolded state to the folded state or from the folded state to the unfolded state. The adhesive layer 530 may be pressed from the second portion 532 toward the first portion 531 by the second region 1002 that is deformed. Since the thickness d1 of the first portion 531 is smaller than the thickness d2 of the second portion 532, the adhesive layer 530 may reduce an inflow of an adhesive material from the first portion 531 to the transmission region 520a.

According to an embodiment, the hinge structure 1030 may be configured to provide a second folding axis f2 in which the second region 1002 is bent with a curvature. The transmission region 520a may be disposed along a second edge 1021 of the fourth housing 1020 facing the second folding axis f2.

For example, at least a portion of the second region 1002 may be bent with a curvature based on the second folding axis f2. The at least a portion of the second region 1002 of the adhesive layer 530 on the second region 1002 may be bent by the bent second region 1002. As the at least portion of the second region 1002 is bent, the adhesive layer 530 may be pressed in a direction (e.g., a -x direction) from the second portion 532 toward the first portion 531.

For example, the first region 1001 of the flexible display 520 may be in contact with the second edge 1021 of the fourth housing 1020 facing the second folding axis f2. The transmission region 520a, which is at least partially surrounded by the first region 1001, may be disposed adjacent to the second edge 1021. The second portion 532 of the adhesive layer 530 disposed on the second region 1002 may be pressed along the second region 1002 deformed based on the second folding axis f2. The adhesive layer 530 may be pressed in a direction (e.g., the -x direction) from the second region 1002 toward the first portion 531 disposed on the first region 1001 as the at least portion of the second region 1002 is bent. As the thickness d1 of the first portion 531 is smaller than the thickness d2 of the second portion 532, the adhesive layer 530 may reduce the inflow of the adhesive material from the first portion 531 to the transmission region 520a. As the thickness d2 of the second portion 532 is greater than the thickness d1 of the first portion 531, the adhesive layer 530 may reduce peeling of the protection film 540 on the second portion 532 according to deformation of the second portion 532.

It has been described that the thickness d1 of the first portion 531 of the adhesive layer 530 is smaller than the thickness d2 of the second portion 532, but it is not limited thereto. According to an embodiment, the thickness d1 of the first portion 531 may be equal to the thickness d2 of the second portion 532 or smaller than the thickness d2 of the second portion 532. As illustrated in FIGS. 6A and 6B, a property of the first portion 531 may be different from a property of the second portion 532 of the adhesive layer 530 in order to reduce the inflow of the adhesive material from the first portion 531 to the transmission region 520a of the flexible display 520. For example, a rigidity of the first portion 531 may be greater than a rigidity of the second portion 532. For example, a hardness of the first portion 531 may be greater than a hardness of the second portion 532. For example, a modulus of the first portion 531 may be greater than a modulus of the second portion 532. For example, an adhesion of the first portion 531 may be greater than an adhesion of the second portion 532. For example, a creep resistance of the first portion 531 may be greater than a creep resistance of the second portion 532. Since the property of the first portion 531 is different from the property of the second portion 532, the adhesive layer 530 may reduce the inflow of the adhesive material from the first portion 531 to the transmission region 520a of the flexible display 520 and increase an adhesion between the adhesive layer 530 and the protection film 540. For example, as illustrated in FIGS. 7A and 7B, the electronic device 101 may further include a coating member 730 sealing a first side surface 711 of the adhesive layer 530 by extending from a second side surface 721 of the protection film 540 to the first region 521 of the flexible display 520. For example, as illustrated in FIG. 8, the electronic device 101 may reduce the inflow of the adhesive material from the first portion 531 to the transmission region 520a by including a protrusion 810. For example, as illustrated in FIGS. 9A to 9D, the electronic devices 101 may reduce the inflow of the adhesive material from the first portion 531 to the transmission region 520a by including the step 910 and/or the mold member 920. However, it is not limited thereto.

The electronic device 101 according to the above-described embodiment may reduce damage to the flexible display 520 due to an external impact by including the protection film 540. The adhesive layer 530 disposed between the flexible display 520 and the protection film 540 may be configured to reduce the inflow of the adhesive material from the first portion 531 to the transmission region 520a, thereby preserving visibility of the camera 510.

According to the above-described embodiment, an electronic device (e.g., the electronic device 101 of FIG. 1) may comprise a camera (e.g., the camera 510 of FIG. 5A). The electronic device may comprise a flexible display (e.g., the flexible display 520 of FIG. 5A) including a transmission region (e.g., the transmission region 520a of FIG. 5A) for receiving light of the camera, a first region (e.g., the first region 521 of FIG. 5A) surrounding the transmission region, and a second region (e.g., the second region 522 of FIG. 5A) which is deformable. The electronic device may comprise an adhesive layer (e.g., the adhesive layer 530 of FIG. 5B) on the flexible display including a first portion (e.g., the first portion 531 of FIG. 5B) disposed on the first region, and a second portion (e.g., the second part 532 of FIG. 5B) disposed on the second region. The electronic device may comprise a protection film (e.g., the protection film 540 of FIG. 5A) disposed on the adhesive layer. A property of the first portion may be different from a property of the second portion. According to the above-mentioned embodiment, the electronic device reduce damage to the flexible display due to an external impact by including the protection film. As a thickness of the first portion is thinner than a thickness of the second portion, the adhesive layer may reduce an inflow of an adhesive material from the first portion to the transmission region. The above-mentioned embodiment may have various effects including the above-mentioned effect.

According to an embodiment, at least one of a rigidity, and an adhesion of the first portion may be greater than at least one of a rigidity, and an adhesion of the second portion corresponding to the first portion.

According to the embodiment, the thickness (e.g., the thickness d1 of FIG. 5B) of the first portion may be smaller than the thickness (e.g., the thickness d2 of FIG. 5B) of the second portion.

According to one embodiment, the rigidity of the first portion may be greater than the rigidity of the second portion. According to the above-mentioned embodiment, as the rigidity of the first portion is greater than the rigidity of the second portion, the adhesive layer may reduce an inflow of an adhesive material from the first portion to the transmission region. The above-mentioned embodiment may have various effects including the above-mentioned effect.

According to an embodiment, the adhesive layer may further include a first adhesive (e.g., the first adhesive 610 of FIG. 6A) forming the first portion, and a second adhesive (e.g., the second adhesive 620 of FIG. 6A) forming the second portion. An adhesion of the first adhesive may be greater than an adhesion of the second adhesive. According to the above-mentioned embodiment, the adhesive layer may reduce an inflow of an adhesive material from the first portion to the transmission region by including the first adhesive and the second adhesive. The above-mentioned embodiment may have various effects including the above-mentioned effect.

According to an embodiment, the electronic device may further comprise a first housing (e.g., the first housing 210 of FIG. 2A), a second housing (e.g., the second housing 220 of FIG. 2A) movable relative to the first housing and on which the transmission region and the first region are disposed. The second region and the second portion may be configured to be rolled in to the first housing or exposed to an outside of the first housing according to the movement of the second housing relative to the first housing. According to the above-mentioned embodiment, the electronic device may provide various user experiences to a user by including the first housing, and the second housing movable relative to the first housing. The above-mentioned embodiment may have various effects including the above-mentioned effect.

According to an embodiment, the first housing may be configured to provide a first folding axis (e.g., the first folding axis f1 of FIG. 5A) where second region is bent with a curvature. The second housing may be configured to be movable in a first direction (e.g., the first direction 261 of FIG. 2A) and a second direction (e.g., the second direction 262 of FIG. 2A) opposite to the first direction relative to the first housing. The transmission region may be disposed along an edge (e.g., the first edge 211 of FIG. 5A) of the second housing facing the first folding axis. According to the above-mentioned embodiment, the electronic device may provide various user experiences to the user by including the first housing and the second housing movable relative to the first housing. The above-mentioned embodiment may have various effects including the above-mentioned effect.

According to an embodiment, the first portion may include a first side surface (e.g., the first side surface 711 of FIG. 7B) surrounding at least a portion of the transmission region when viewing the flexible display from above. The protection film may include a second side surface (e.g., the second side surface 721 of FIG. 7A) surrounding at least a portion of the transmission region when viewing the flexible display from above. According to the above-mentioned embodiment, the electronic device may be configured to preserve visibility of the camera by including the first side surface and the second side surface. The above-mentioned embodiment may have various effects including the above-mentioned effect.

According to an embodiment, the electronic device may further comprise a coating member (e.g., the coating member 730 of FIG. 7A) sealing the first side surface by extending from the second side surface to the first region. According to the above-mentioned embodiment, the electronic device may reduce an inflow of an adhesive material from the first portion to the transmission region by including the coating member. The above-mentioned embodiment may have various effects including the above-mentioned effect.

According to an embodiment, the first portion may include a first side portion (e.g., the first side portion 710 of FIG. 9B) including a first side surface surrounding at least a portion of the transmission region when viewing the flexible display from above and a third side surface (e.g., the third side surface 712 of FIG. 9B) extending from the first side surface. The protection film may include a second side portion (e.g., the second side portion 720 of FIG. 9B) including a second side surface surrounding at least a portion of the transmission region when viewing the flexible display from above and a fourth side surface (e.g., the fourth side surface 722 of FIG. 7A) extending from the second side surface, and having a step (e.g., the step 910 of FIG. 7B) with respect to the first side portion in order to reduce an inflow of an adhesive material from the adhesive layer to the transmission region. According to the above-mentioned embodiment, the protection film may reduce the inflow of the adhesive material from the first portion to the transmission region by having the step with respect to the adhesive layer. The above-mentioned embodiment may have various effects including the above-mentioned effect.

According to an embodiment, the step may include a first step portion (e.g., the first step portion 911 of FIG. 9B) extending from the first side surface to the third side surface, and a second step portion (e.g., the second step portion 912 of FIG. 9B) contacting the first step portion and extending from the second side surface to the fourth side surface. According to the above-mentioned embodiment, the protection film may reduce an inflow of an adhesive material from the first portion to the transmission region by having the step with respect to the adhesive layer. The above-mentioned embodiment may have various effects including the above-mentioned effect.

According to an embodiment, the electronic device may further comprise a mold member (e.g., the mold member 920 of FIG. 9D) contacting the step and the first region and at least partially facing the second side portion. According to the above-mentioned embodiment, the electronic device may reduce an inflow of an adhesive material from the first portion to the transmission region by including the mold member. The above-mentioned embodiment may have various effects including the above-mentioned effect.

According to an embodiment, the flexible display may further include a protrusion (e.g., the protrusion 810 of FIG. 8) protruding from the first region and at least partially facing the first portion in order to reduce an inflow of an adhesive material from the adhesive layer to the transmission region. According to the above-mentioned embodiment, the flexible display may reduce the inflow of the adhesive material from the first portion to the transmission region by including the protrusion. The above-mentioned embodiment may have various effects including the above-mentioned effect.

According to an embodiment, the transmission region may include a camera hole (e.g., the camera hole 630 of FIG. 6B) exposing at least a portion of the camera. According to the above-mentioned embodiment, the transmission region may increase a display region of the flexible display by including the camera hole. The above-mentioned embodiment may have various effects including the above-mentioned effect.

According to an embodiment, the flexible display may further include a window (e.g., the window 640 of FIG. 6B) and an anti fingerprint layer (e.g., the anti fingerprint layer 650 of FIG. 6B) layered on the window and contacting the adhesive layer. According to the above-mentioned embodiment, the flexible display may reduce a foreign substance introduced into the window from an outside by including the anti fingerprint layer on the window. The above-mentioned embodiment may have various effects including the above-mentioned effect.

According to an embodiment, the electronic device may further comprise a third housing (e.g., the third housing 1010 of FIG. 10A), a fourth housing (e.g., the fourth housing 1020 of FIG. 10A) on which the transmission region and the first region are disposed, and a hinge structure (e.g., the hinge structure 1030 of FIG. 10A) rotatably connecting the third housing and the fourth housing and disposed under the second region. According to the above-mentioned embodiment, the electronic device may provide various user experiences to the user by including the hinge structure rotatably connecting the third housing and the fourth housing. The above-mentioned embodiment may have various effects including the above-mentioned effect.

According to an embodiment, the hinge structure may be configured to provide a second folding axis (e.g., the second folding axis f2 of FIG. 10A) where second region bent with a curvature. The transmission region may be disposed along an edge (e.g., the second edge 1021 of FIG. 10A) of the fourth housing facing the second folding axis. According to the above-mentioned embodiment, the electronic device may provide various user experiences to the user by including the hinge structure rotatably connecting the third housing and the fourth housing. The above-mentioned embodiment may have various effects including the above-mentioned effect.

According to an embodiment, an electronic device may comprise a camera. The electronic device may comprise a flexible display including a transmission region for receiving light of the camera and including a camera hole exposing at least a portion of the camera, a first region surrounding the transmission region, and a second region which is deformable. The electronic device may comprise an adhesive layer on the flexible display including a first portion disposed on the first region, and a second portion disposed on the second region. The electronic device may comprise a protection film disposed on the adhesive layer. A thickness of the first portion may be smaller than a thickness of the second portion. A rigidity of the first portion may be greater than a rigidity of the second portion. According to the above-mentioned embodiment, the electronic device may reduce damage to the flexible display due to an external impact by including the protection film. As the thickness of the first portion is thinner than the thickness of the second portion, the adhesive layer may reduce an inflow of an adhesive material from the first portion to the transmission region. As the rigidity of the first portion is greater than the rigidity of the second portion, the adhesive layer may reduce the inflow of the adhesive material from the first portion to the transmission region. The above-mentioned embodiment may have various effects including the above-mentioned effect.

According to an embodiment, the adhesive layer further may include a first adhesive forming the first portion, and a second adhesive forming the second portion. An adhesion of the first adhesive may be greater than an adhesion of the second adhesive. According to the above-mentioned embodiment, the adhesive layer may reduce an inflow of an adhesive material from the first portion to the transmission region by including the first adhesive and the second adhesive. The above-mentioned embodiment may have various effects including the above-mentioned effect.

According to an embodiment, the electronic device may further comprise a first housing, a second housing movable relative to the first housing and on which the transmission region and the first region are disposed. The second region and the second portion may be configured to be rolled in to the first housing or exposed to an outside of the first housing according to the movement of the second housing relative to the first housing. According to the above-mentioned embodiment, the electronic device may provide various user experiences to a user by including the first housing and the second housing movable relative to the first housing. The above-mentioned embodiment may have various effects including the above-mentioned effect.

According to an embodiment, the first portion may include a first side portion including a first side surface surrounding at least a portion of the transmission region when viewing the flexible display from above and a third side surface extending from the first side surface. The protection film may include a second side portion including a second side surface surrounding at least a portion of the transmission region when viewing the flexible display from above and a fourth side surface extending from the second side surface, and having a step with respect to the first side portion in order to reduce an inflow of an adhesive material from the adhesive layer to the transmission region. According to the above-mentioned embodiment, the protection film may reduce an inflow of an adhesive material from the first portion to the transmission region by having the step with respect to the adhesive layer. The above-mentioned embodiment may have various effects including the above-mentioned effect.

According to an embodiment, the flexible display may further include a protrusion protruding from the first region and at least partially facing the first portion in order to reduce an inflow of an adhesive material from the adhesive layer to the transmission region. According to the above-mentioned embodiment, the flexible display may reduce the inflow of the adhesive material from the first portion to the transmission region by including the protrusion. The above-mentioned embodiment may have various effects including the above-mentioned effect.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a camera (510);
a flexible display (520) including a transmission region (520a) for receiving light of the camera (510), a first region (521) surrounding the transmission region, and a second region (522) which is deformable;
an adhesive layer (530) on the flexible display(520) including a first portion (531) disposed on the first region (521), and a second portion (532) disposed on the second region (522); and
a protection film (540) disposed on the adhesive layer(530);
wherein, a property of the first portion (531) is different from a property of the second portion (532).

2. The electronic device of claim 1,
wherein, at least one of a rigidity, and an adhesion of the first portion (531) is greater than at least one of a rigidity, and an adhesion of the second portion (532) corresponding to the first portion (531).

3. The electronic device of claim according to any one of claims 1 or 2,
wherein, a thickness of the first portion (531) is smaller than a thickness of the second portion (532).

4. The electronic device of claim according to any one of claims 1 to 3, further comprising:
a first housing (210);
a second housing (220) movable relative to the first housing and on which the transmission region (520a) and the first region (521) are disposed; and,
wherein, the second region (522) and the second portion (532) are configured to be rolled in to the first housing (210) or exposed to an outside of the first housing (210) according to the movement of the second housing (220) relative to the first housing.

5. The electronic device of claim according to any one of claims 1 to 4,
wherein, the first housing (210) is configured to provide a first folding axis (f1) where second region (522) is bent with a curvature, and
wherein, the second housing (220) is configured to be movable in a first direction (261) and a second direction (262) opposite to the first direction (261) relative to the first housing (210), and
wherein, the transmission region (520a) is disposed along an edge (221) of the second housing (220) facing the first folding axis (f1).

6. The electronic device of claim according to any one of claims 1 to 5,
wherein, the first portion (531) includes a first side surface (711) surrounding at least a portion of the transmission region (520a) when viewing the flexible display (520) from above, and
wherein, the protection film (540) includes a second side surface (721) surrounding at least a portion of the transmission region (520a) when viewing the flexible display (520) from above.

7. The electronic device of claim according to any one of claims 1 to 6, further comprising:
a coating member (730) sealing the first side surface (711) by extending from the second side surface (721) to the first region (521).

8. The electronic device of claim according to any one of claims 1 to 7,
wherein, the first portion (531) includes a first side portion (710) including a first side surface (711) surrounding at least a portion of the transmission region (520a) when viewing the flexible display (520) from above and a third side surface (712) extending from the first side surface (711), and
wherein, the protection film (540) includes a second side portion including a second side surface (721) surrounding at least a portion of the transmission region (520a) when viewing the flexible display (520) from above and a fourth side surface (722) extending from the second side surface (721), and having a step (910) with respect to the first side portion (710) in order to reduce an inflow of an adhesive material from the adhesive layer to the transmission region (520a).

9. The electronic device of claim according to any one of claims 1 to 8,
wherein, the step (910) includes a first step portion (911) extending from the first side surface (711) to the third side surface (712), and a second step portion (912) contacting the first step portion (911) and extending from the second side surface (721) to the fourth side surface (722).

10. The electronic device of claim according to any one of claims 1 to 9, further comprising:
a mold member (920) contacting the step (910) and the first region (521) and sealing the first side portion (710).

11. The electronic device of claim according to any one of claims 1 to 10,
wherein, the flexible display (520) further includes a protrusion (810) protruding from the first region (521) and at least partially facing the first portion (531) in order to reduce an inflow of an adhesive material from the adhesive layer (530) to the transmission region (520a).

12. The electronic device of claim according to any one of claims 1 to 11,
wherein, the transmission region (520a) includes a camera hole (630) exposing at least a portion of the camera (510).

13. The electronic device of claim according to any one of claims 1 to 12, further comprising:
a third housing (1010);
a fourth housing (1020) on which the transmission region (520a) and the first region (521) are disposed; and
a hinge structure (1030) rotatably connecting the third housing (1010) and the fourth housing (1020) and disposed under the second region (522).

14. The electronic device of claim according to any one of claims 1 to 13,
wherein, the hinge structure (1030) is configured to provide a second folding axis (f2) where second region (522) bent with a curvature, and
wherein, the transmission region (520a) is disposed along an edge (1021) of the fourth housing (1020) facing the second folding axis (f2).

15. The electronic device of claim according to any one of claims 1 to 14,
wherein a creep resistance of the first portion (531) is greater than a creep resistance of the second portion (532).
